(19) Europäisches Patentamt / European Patent Office / Office européen des brevets

(11) **EP 3 116 029 A1**

(12) **EUROPEAN PATENT APPLICATION**
published in accordance with Art. 153(4) EPC


(43) Date of publication:
**11.01.2017 Bulletin 2017/02**

(21) Application number: **15758158.8**

(22) Date of filing: **26.02.2015**

(51) Int Cl.:
***H01L 29/786*** *(2006.01)* ***H01L 51/05*** *(2006.01)*
***H01L 51/30*** *(2006.01)*

(86) International application number:
**PCT/JP2015/055706**

(87) International publication number:
**WO 2015/133374 (11.09.2015 Gazette 2015/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **07.03.2014 JP 2014045166**



(71) Applicant: **Fujifilm Corporation**
**Minato-ku**
**Tokyo 106-8620 (JP)**

(72) Inventor: **NIORI, Teruki**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**


(54) **ORGANIC THIN FILM TRANSISTOR**


(57) Provided is an organic thin-film transistor which is a bottom-gate type organic thin-film transistor including a substrate; a gate electrode provided on the substrate; a first gate insulating layer provided to cover the gate electrode; a second gate insulating layer provided on the first gate insulating layer; an organic semiconductor layer provided on the second gate insulating layer; and a source electrode and a drain electrode provided in contact with the organic semiconductor layer and connected to each other through the organic semiconductor layer, in which the surface of the first gate insulating layer on the second gate insulating layer side is subjected to an alignment treatment, and the second gate insulating layer is a layer formed by polymerizing and immobilizing a polymerizable crystalline compound aligned in accordance with the alignment treatment, in the aligned state.


FIG. 1A

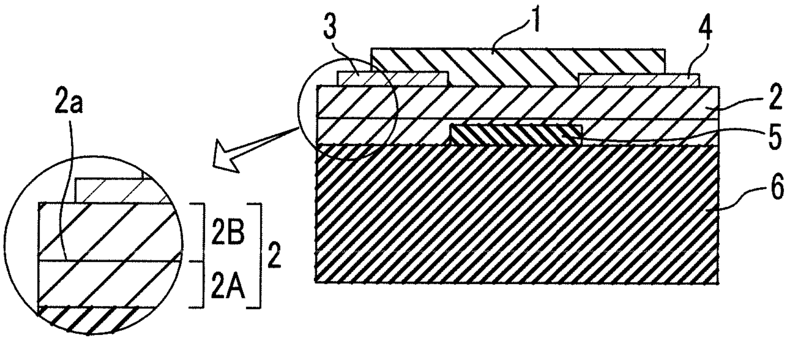


EP 3 116 029 A1

FIG. 1B

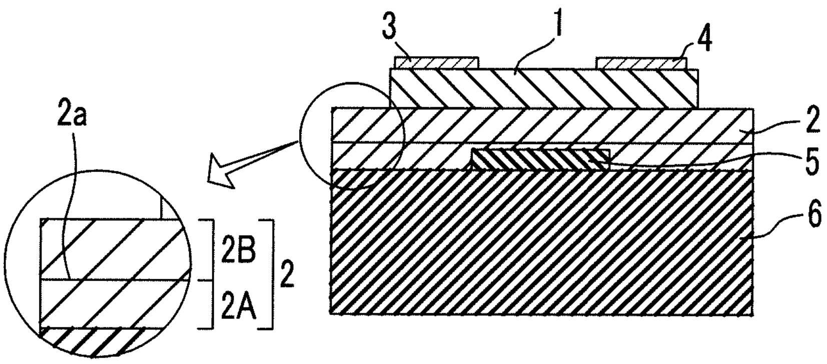

**Description**

**BACKGROUND OF THE INVENTION**

1. Field of the Invention

The present invention relates to an organic thin-film transistor.

2. Description of the Related Art

Most of display devices such as a liquid crystal display, an organic EL display, and an electrophoretic display have a thin-film transistor (hereinafter, also referred to as a "TFT") incorporated therein as a display switching device. A TFT has a structure, on a substrate, formed of a gate electrode, a semiconductor layer, and a gate insulating layer provided between the gate electrode and the semiconductor layer, and a source electrode and a drain electrode are further provided in contact with the semiconductor layer. The TFT is driven by applying a voltage to the gate electrode. By applying a voltage to the gate electrode, the amount of carriers formed of electrons or holes in a semiconductor is controlled so that the current flowing between the source electrode and the drain electrode is controlled.

In the related art, an inorganic semiconductor such as amorphous or polycrystalline thin-film silicon has been used for a semiconductor used for a TFT. However, in a case where a semiconductor layer of a TFT is formed of an inorganic semiconductor, a vacuum process or a high-temperature process carried out at 300°C or higher is required and thus improvement of productivity is restricted.

In contrast, a TFT using an organic semiconductor has become popular in recent years. Since an organic semiconductor layer can be formed using a method such as an ink-jet method, spin coating, or flexographic printing, the film-forming process can be efficiently performed at a low temperature, at a high speed, and at low cost.

In an organic semiconductor layer, carrier mobility can be increased and a switching operation can be performed at a higher speed by improving the alignment of an organic semiconductor constituting the organic semiconductor layer. For example, JP4349307B describes that an organic semiconductor is aligned along the alignment direction of a gate insulating layer, at the time of manufacturing a bottom-gate type organic thin-film transistor, by forming an underlayer aligned on a substrate in a predetermined direction, forming a gate electrode on the underlayer, forming a gate insulating layer so as to cover the gate electrode in a state in which a part of the gate insulating layer is in contact with the underlayer, aligning the gate insulating layer along the alignment direction of the underlayer, and forming an organic semiconductor layer so as to come into contact with the gate insulating layer.

Further, JP2005-72200A describes a field-effect type organic transistor in which at least one layer of gate insulating layers has dielectric isotropy and which is formed of a liquid crystal polymer. With the configuration of the transistor described in JP2005-72200A, alignment of an organic semiconductor formed on a gate insulating layer is controlled.

**SUMMARY OF THE INVENTION**

However, in the method of manufacturing an organic thin-film transistor described in JP4349307B, since the gate electrode is formed on a portion of the underlayer aligned in a predetermined direction, an alignment regulation force of the underlayer immediately above where the gate insulating layer is present is lost. Accordingly, it is not possible to align the organic semiconductor throughout the organic semiconductor layer formed on the gate insulating layer.

Further, the field-effect type organic transistor described in JP2005-72200A exhibits fluidity because alignment of the gate insulating layer is not immobilized and thus cracks easily occur in the crystal of the organic semiconductor layer formed thereon and the performance is likely to be degraded. Particularly, since the alignment of the gate insulating layer is easily lost when exposed to a temperature higher than the liquid crystal forming temperature, it cannot be said that the heat resistance of the field-effect type organic transistor described in JP2005-72200A is sufficient.

An object of the present invention is to provide an organic thin-film transistor which exhibits excellent carrier mobility and has excellent heat resistance.

The above-described objects are achieved by the following means.

[1] A bottom gate type organic thin-film transistor comprising: a substrate; a gate electrode provided on the substrate; a first gate insulating layer provided to cover the gate electrode; a second gate insulating layer provided on the first gate insulating layer; an organic semiconductor layer provided on the second gate insulating layer; and a source electrode and a drain electrode provided in contact with the organic semiconductor layer and connected to each other through the organic semiconductor layer, in which the surface of the first gate insulating layer on the second gate insulating layer side is subjected to an alignment treatment, and the second gate insulating layer comprises

polymerized and immobilized liquid crystalline compound aligned in accordance with the alignment treatment, which is formed by polymerizing and immobilizing a polymerizable liquid crystalline compound in the aligned state.

[2] The organic thin-film transistor according to [1], in which the polymerizable liquid crystalline compound is a rod-like liquid crystalline compound, and a liquid crystal phase of the polymerizable liquid crystalline compound is a nematic phase or a smectic phase in the aligned state in accordance with the alignment treatment.

[3] The organic thin-film transistor according to [1], in which the polymerizable liquid crystalline compound is a discotic liquid crystalline compound, and a liquid crystal phase of the polymerizable liquid crystalline compound is a discotic nematic phase in the aligned state in accordance with the alignment treatment.

[4] The organic thin-film transistor according to any one of [1] to [3], in which the polymerized and immobilized liquid crystalline compound is aligned horizontally on the surface of the second gate insulating layer on the organic semiconductor layer side.

[5] The organic thin-film transistor according to any one of [1] to [3], in which the polymerized and immobilized liquid crystalline compound is aligned vertically on the surface of the second gate insulating layer on the organic semiconductor layer side.

[6] The organic thin-film transistor according to any one of [1] to [3], in which the polymerized and immobilized liquid crystalline compound is aligned obliquely on the surface of the second gate insulating layer on the organic semiconductor layer side.

[7] The organic thin-film transistor according to any one of [1] to [6], in which the first gate insulating layer contains an organic polymer compound selected from polyimide, polyvinyl phenol, a novolak resin, polystyrene, poly(meth)acrylate, an epoxy resin, epoxy (meth)acrylate, polyvinyl alcohol, a fluorine resin, polycycloolefin, polysilsesquioxane, polysiloxane, polyester, polyether sulfone, and polyether ketone.

In the present specification, when a plurality of substituents or linking groups (hereinafter, referred to as substituents or the like) shown by specific symbols are present or a plurality of substituents are defined simultaneously or alternatively, this means that the respective substituents may be the same as or different from each other. The same applies to the regulation of the number of substituents or the like. Moreover, in a case where there is a repetition of a plurality of partial structures which are displayed in the same manner in the formula, the respective partial structures or repeating units may be the same as or different from each other. In addition, even in a case where not specifically stated, when a plurality of substituents or the like are adjacent (particularly, neighboring) to each other, they may be condensed or linked to each other and form a ring.

In regard to compounds (including polymers) described in the present specification, the description includes salts thereof and ions thereof in addition to the compounds. Further, the description includes partially changed structures within the range in which desired effects are exhibited.

In the present specification, substituents (the same applies to linking groups) in which substitution or non-substitution is not specified may further include substituents within the range in which desired effects are exhibited. The same applies to compounds in which substitution or non-substitution is not specified.

In addition, the numerical ranges shown using "to" in the present specification indicate ranges including the numerical values shown before and after "to" as the lower limits and the upper limits.

The organic thin-film transistor of the present invention exhibits excellent carrier mobility and is capable of performing a switching operation at a higher speed. Further, the organic thin-film transistor of the present invention also has excellent heat resistance. Therefore, the immobilized aligned state of the gate insulating layer is not damaged even in a case where the temperature of the organic thin-film transistor is increased due to a high voltage and a high current, the switching operation is excellently performed at a higher speed, and the performance is unlikely to be degraded.

The above-described and other features and advantages of the present invention will become apparent from the description below with reference to the accompanying drawings.

## BRIEF DESCRIPTION OF THE DRAWINGS

Figs. 1A and 1B are views schematically illustrating an organic thin-film transistor according to preferred embodiments of the present invention.

## DESCRIPTION OF THE PREFERRED EMBODIMENTS

Hereinafter, the present invention will be described in detail.

[Organic thin-film transistor]

Embodiments of an organic thin-film transistor of the present invention (hereinafter, also simply referred to as

an "OTFT of the present invention) will be described in detail below.

The OTFT of the present invention is a bottom-gate type transistor and includes a substrate; a gate electrode provided on the substrate; a first gate insulating layer provided to cover the gate electrode; a second gate insulating layer provided on the first gate insulating layer; an organic semiconductor layer provided on the second gate insulating layer; and a source electrode and a drain electrode provided in contact with the organic semiconductor layer and connected to each other through the organic semiconductor layer. When a voltage is applied to the gate electrode, a channel of a current is formed on the interface between a semiconductor layer, positioned between the source electrode and the drain electrode, and a layer adjacent to the semiconductor layer. That is, the current flowing between the source electrode and the drain electrode is controlled according to the input voltage applied to the gate electrode.

Preferred embodiments of the OTFT according to the present invention will be described with reference to the accompanying drawings. The drawings illustrating respective OTFT are schematic views for facilitating understanding the present invention, and the size or the relative magnitude relation of each member is occasionally changed for the sake of convenience. Each member is not illustrated in actual scale. Moreover, the present invention is not limited to the outer shapes or shapes illustrated in the figures except definitions described in the present invention.

Figs. 1A and 1B are respectively longitudinal sectional views schematically illustrating the OTFT according to preferred exemplary embodiments of the present invention. In Figs. 1A and 1B, the reference numeral 1 indicates an organic semiconductor layer, the reference numeral 2 indicates a gate insulating layer, the reference numeral 3 indicates a source electrode, the reference numeral 4 indicates a drain electrode, the reference numeral 5 indicates a gate electrode, and the reference numeral 6 indicates a substrate. The gate insulating layer 2 is formed of a first gate insulating layer 2A and a second gate insulating layer 2B. A surface 2a of the first gate insulating layer 2A on the second gate insulating layer side is subjected to an alignment treatment. A liquid crystalline compound which is a constituent material of the second gate insulating layer can be aligned in accordance with the alignment treatment.

Further, Fig. 1A illustrates a bottom-gate bottom-contact type OTFT and Fig. 1B illustrates a bottom-gate top-contact type OTFT. The OTFT of the present invention has the above-described two types. Although not illustrated, an overcoat layer is formed on the uppermost portion (on the opposite side to the substrate 6) of the surface of each OTFT in some cases.

Members and materials constituting the OTFT of the present invention will be described below.

[Substrate]

A substrate which is capable of supporting the OTFT and a display panel or the like prepared on the OTFT can be used. The substrate is not particularly limited as long as the substrate has a sheet shape and the surface thereof is insulating and flat.

An inorganic material may be used as the material of the substrate. Examples of the substrate formed of an inorganic material include various glass substrates such as soda-lime glass and quartz glass, various glass substrates having an insulating film formed on the surface thereof, a quartz substrate having an insulating film formed on the surface thereof, a silicon substrate having an insulating film formed on the surface thereof, a sapphire substrate, metal substrates made of various alloys or various metals such as stainless steel, aluminum, and nickel, metal foil, and paper.

In a case where the substrate is formed of a semiconductive material or a conductive material such as a stainless sheet, aluminum foil, copper foil, or a silicon wafer, the surface thereof is typically coated with or overlapped with an insulating polymer material or a metal oxide for use.

Moreover, an organic material may also be used as the material of the substrate. Examples thereof include a plastic substrate (also referred to as a plastic film or a plastic sheet) which has flexibility and is formed of an organic polymer such as polymethylmethacrylate (PMMA), polyvinyl alcohol (PVA), polyvinyl phenyl (PVP), polyether sulfone (PES), polyimide, polyamide, polyacetal, polycarbonate (PC), polyethylene terephthalate (PET), polyethylene naphthalene (PEN), polyethyl ether ketone, polyolefin, or polycycloolefin. Further, a material formed from mica can be also exemplified.

When such a plastic substrate or the like having flexibility is used, incorporation or integration of the OTFT into/with a display device or an electronic device having a curved shape becomes possible.

Since an organic material forming the substrate is unlikely to be softened at the time of lamination on another layer or being heated, it is preferable that the glass transition point thereof is high, for example, 40°C or higher. Moreover, in terms that dimensional change resulting from a heat treatment at the time of production is unlikely to occur and stability of transistor performance is excellent, it is preferable that the linear expansion coefficient is small. For example, a material having a linear expansion coefficient of $25 \times 10^{-5}$ cm/cm·°C or less is preferable and a material having a linear expansion coefficient of $10 \times 10^{-5}$ cm/cm·°C or less is more preferable.

Further, as the organic material constituting the substrate, a material having resistance to a solvent used when the OTFT is produced is preferable and a material having excellent adhesion to a gate insulating layer and an electrode is preferable.

Moreover, it is preferable to use a plastic substrate formed of an organic polymer having excellent gas barrier properties.

It is also preferable that a dense silicon oxide film or the like is provided on at least one surface of the substrate or an inorganic material is deposited or laminated on at least one surface of the substrate.

Other examples of the substrate include conductive substrates (for example, a substrate formed of a metal such gold or aluminum, a substrate formed of highly oriented graphite, or stainless steel substrate).

A buffer layer used to improve the adhesion or flatness, a functional film such as a barrier film used to improve gas barrier properties, or a surface treatment layer such as an easily adhesive layer may be formed on the surface of the substrate or the substrate may be subjected to a surface treatment such as a corona treatment, a plasma treatment, or UV/ozone treatment.

The thickness of the substrate is preferably 10 mm or less, more preferably 2 mm or less, and particularly preferably 1 mm or less. Further, the thickness thereof is preferably 0.01 mm or greater and more preferably 0.05 mm or greater. Particularly, in a case of a plastic substrate, the thickness thereof is preferably in a range of 0.05 mm to 0.1 mm. Moreover, in a case of a substrate formed of an inorganic material, the thickness thereof is preferably in a range of 0.1 mm to 10 mm.

[Gate electrode]

A known electrode of the related art being used as a gate electrode of an OTFT can be used as the gate electrode. A conductive material (also referred to as an electrode material) constituting the gate electrode is not particularly limited. Examples thereof include metals such as platinum, gold, silver, aluminum, chromium, nickel, copper, molybdenum, titanium, magnesium, calcium, barium, sodium, palladium, iron, and manganese; conductive metal oxides such as $InO_2$, $SnO_2$, indium tin oxide (ITO), fluorine-doped tin oxide (FTO), aluminum-doped zinc oxide (AZO), and gallium-doped zinc oxide (GZO); conductive polymers such as polyaniline, polypyrrole, polythiophene, polyacetylene, and poly(3,4-ethylenedioxythiophene)/polystyrene sulfonic acid (PEDOT/PSS); and conductive composite materials obtained by dispersing the above-described conductive polymer to which a dopant, for example, an acid such as hydrochloric acid, sulfuric acid, or sulfonic acid, Lewis acid such as $PF_6$, $AsF_5$, or $FeCl_3$, a halogen atom such as iodine, or a metal atom such as sodium or potassium is added, carbon black, graphite powder, or metal fine particles therein. These materials may be used alone or in combination of optional two or more kinds thereof at an optional ratio.

In addition, the gate electrode may be configured of a single layer or two or more layers being laminated, formed of the above-described conductive materials.

A method of forming the gate electrode is not limited. Examples thereof include a method of patterning a film, formed using a physical vapor deposition (PVD) method such as a vacuum vapor deposition method, a chemical vapor deposition method (CVD method), a sputtering method, a printing method (coating method), a transfer method, a sol-gel method, or a plating method, in a desired shape as needed.

According to the coating method, a film is formed or an electrode is directly formed by preparing, applying, drying, baking, photocuring, or aging a solution, paste, or a dispersion liquid of the above-described material.

Moreover, from the viewpoints of capability of desired patterning, simplifying the processes, cost reduction, and speeding up, it is preferable to use ink jet printing, screen printing, (inversion) offset printing, relief printing, intaglio printing, planographic printing, thermal transfer printing, or a microcontact printing method.

In a case where a spin coating method, a die coating method, a micro gravure coating method, or a dip coating method is employed, patterning can be carried out by combining any of these method and the following photolithographic method.

As the photolithographic method, a method of combining patterning of a photoresist, etching, for example, wet etching using an etching solution or dry etching using a reactive plasma, and a lift-off method may be exemplified.

As another patterning method, a method of irradiating the above-described materials with energy rays such as laser or electron beams and polishing the materials so that the conductivity of the material is changed may be exemplified.

In addition, a method of transferring a composition for a gate electrode which is printed on a support other than a substrate onto an underlayer such as the substrate may be exemplified.

The thickness of the gate electrode is optional, but is preferably 1 nm or greater and particularly preferably 10 nm or greater. Further, the thickness thereof is preferably 500 nm or less and particularly preferably 200 nm or less.

[Gate insulating layer]

<First gate insulating layer>

The first gate insulating layer is not particularly limited as long as the layer has insulating properties and the gate insulating layer may be formed of a single layer or multiple layers.

It is preferable that the first gate insulating layer is formed of an insulating material, and preferred examples of the insulating material include an organic polymer and an inorganic oxide.

The organic polymer and the inorganic oxide are not particularly limited as long as the organic polymer and the inorganic oxide have insulating properties, and it is preferable that the organic polymer and the inorganic oxide are formed of a thin film having a thickness of 1 μm or less.

The organic polymer and the inorganic oxide may be used alone or in combination of two or more kinds thereof and the organic polymer may be combined with the inorganic oxide.

The organic polymer is not particularly limited, and examples thereof include polyvinyl phenol, polystyrene (PS), poly(meth)acrylate represented by polymethyl methacrylate, polyvinyl alcohol, polyvinyl chloride (PVC), polyvinylidene fluoride (PVDF), polytetrafluoroethylene (PTFE), a cyclic fluoroalkyl polymer represented by CYTOP, polycycloolefin, polyester, polyether sulfone, polyether ketone, polyimide, an epoxy resin, polyorganosiloxane represented by polydimethylsiloxane (PDMS), polysilsesquioxane, and butadiene rubber. Further, other examples thereof include thermosetting resins such as a phenolic resin, a novolak resin, a cinnamate resin, an acrylic resin, and a polyparaxylylene resin.

The organic polymer can be combined with a compound including a reactive substituent such as an alkoxysilyl group, a vinyl group, an acryloyloxy group, an epoxy group, or a methylol group.

In a case where the first gate insulating layer is formed using an organic polymer, it is also preferable that the organic polymer is cross-linked and cured for the purpose of increasing the solvent resistance or insulation resistance of the first gate insulating layer. It is preferable that the crosslinking is performed by generating an acid or a radical using light or heat or both of these.

In a case where the crosslinking is performed by generating a radical, as a radical generator that generates a radical using light or heat, for example, a thermal polymerization initiator (H1) and a photopolymerization initiator (H2) described in the paragraphs [0182] to [0186] of JP2013-214649A, a photo-radical generator described in the paragraphs [0046] to [0051] of JP2011-186069A, and a photo-radical polymerization initiator described in the paragraphs [0042] to [0056] of JP2010-285518A can be preferably used, and it is preferable that the contents of which are incorporated in the specification of the present application.

Moreover, it is preferable that "a compound (G) which has a number average molecular weight (Mn) of 140 to 5,000, includes a crosslinkable functional group, and does not include a fluorine atom" described in the paragraphs [0167] to [0177] of JP2013-214649A is preferably used and the contents of which are incorporated in the specification of the present application.

In a case where the crosslinking is performed by generating an acid, as a photoacid generator that generates an acid using light, for example, a photocationic polymerization initiator described in the paragraphs [0033] and [0034] of JP2010-285518A, and an acid generator, particularly sulfonium salts and iodonium salts described in the paragraphs [0120] to [0136] of JP2012-163946A can be preferably used, and it is preferable that the contents of which are incorporated in the specification of the present application.

As a thermal acid generator (catalyst) that generates an acid using heat, for example, a thermal cationic polymerization initiator and particularly onium salts described in the paragraphs [0035] to [0038] of JP2010-285518A, and a catalyst and particularly sulfonic acids and sulfonic acid amine salts described in the paragraphs [0034] and [0035] of JP2005-354012A can be preferably used, and it is preferable that the contents of which are incorporated in the specification of the present application.

Moreover, a crosslinking agent and particularly a difunctional or higher functional epoxy compound and an oxetane compound described in the paragraphs [0032] and [0033] of JP2005-354012A, a crosslinking agent and particularly a compound which includes two or more crosslinking group and in which at least one of the crosslinking groups is a methylol group or an NH group described in the paragraphs [0046] to [0062] of JP2006-303465A, and a hydroxymethyl group or a compound having two or more alkoxymethyl groups in a molecule described in the paragraphs [0137] to [0145] of JP2012-163946A are preferably used, and it is preferable that the contents of which are incorporated in the specification of the present application.

It is more preferable that the first gate insulating layer contains an organic polymer selected from polyimide, polyvinyl phenol, a novolak resin, polystyrene, poly(meth)acrylate, an epoxy resin, epoxy (meth)acrylate, polyvinyl alcohol, a fluorine resin, polycycloolefin, polysilsesquioxane, polysiloxane, polyester, polyether sulfone, and polyether ketone and still more preferable that the first gate insulating layer is formed of these organic polymers.

As the fluorine resin, polyvinylidene fluoride or polytetrafluoroethylene is preferable. As the polysiloxane, dialkyl polysiloxane is preferable and polydimethylsiloxane is more preferable.

The organic polymer contained in the first gate insulating layer may form a cross-linked structure as described above. Further, the organic polymer may have a form of a copolymer having a constituent component of the organic polymer as a constituent unit.

As a method of forming the first gate insulating layer with an organic polymer, a method of applying and curing an organic polymer may be exemplified. The coating method is not particularly limited, and the above-described various printing methods are exemplified. Among those, a wet coating method such as a micro gravure coating method, a dip

coating method, screen coating printing, a die coating method, or a spin coating method is preferable.

The inorganic oxide is not particularly limited, and examples thereof include oxides such as silicon oxide, silicon nitride (SiNγ), hafnium oxide, titanium oxide, tantalum oxide, aluminum oxide, niobium oxide, zirconium oxide, copper oxide, and nickel oxide; perovskites such as $SrTiO_3$, $CaTiO_3$, $BaTiO_3$, $MgTiO_3$, and $SrNb_2O_6$; and a composite oxide or a mixture of these. Here, as the silicon oxide, in addition to silicon oxide ($SiO_x$), BPSG, PSG, BSG, AsSG, PbSG, silicon oxynitride (SiON), spin on glass (SOG), and $SiO_2$-based materials having a low dielectric constant (for example, polyaryl ether, a cycloperfluorocarbon polymer, benzocyclobutene, a cyclic fluorine resin, polytetrafluoroethylene, fluorinated aryl ether, fluorinated polyimide, amorphous carbon, and organic SOG) are included.

As a method forming the first gate insulating layer with an inorganic oxide, a vacuum film formation method such as a vacuum vapor deposition method, a sputtering method, ion plating, or a CVD method can be used, and assist may be performed using a plasma, an ion gun, or a radical gun using optional gas during the film formation.

Moreover, the gate insulating layer may be formed by reacting a precursor corresponding to each metal oxide, specifically, a metal halide or a metal alkoxide such as a chloride or a bromide, or a metal hydroxide with an acid such as hydrochloric acid, sulfuric acid, or nitric acid, or a base such as sodium hydroxide or potassium hydroxide in alcohol or water for hydrolysis. In a case of using such a solution-based process, the above-described wet coating method can be used.

The first gate insulating layer can be also provided using a method obtained by combining any one of a lift-off method, a sol-gel method, an electrodeposition method, and a shadow mask method with a patterning method, if necessary, other than the above-described methods.

The first gate insulating layer may be subjected to a surface treatment such as a corona treatment, a plasma treatment, or a UV/ozone treatment.

- Alignment treatment applied to surface of first gate insulating layer -

The surface of the first gate insulating layer on the second gate insulating layer side is subjected to an alignment treatment. The alignment treatment method is not particularly limited, and a known alignment treatment method of the related art can be employed. For example, the alignment treatment can be carried out using a rubbing treatment of an organic compound (preferably a polymer) constituting the first insulating layer, oblique vapor deposition of an inorganic compound, formation of a layer having microgrooves, or accumulation of an organic compound (for example, ω-tricosanoic acid or methyl stearate) according to the Langmuir-Blodgett method (LB film). Further, the alignment treatment can be also carried out by applying an electric field or a magnetic field to the organic compound constituting the surface of the first insulating layer or irradiating the organic compound constituting the surface of the first insulating layer with light (linearly polarized irradiation or non-polarized irradiation).

Among the above-described examples, in the present invention, it is preferable to employ a method of constituting at least the surface of the first gate insulating layer on the second gate insulating layer side with a polymer and rubbing the surface of the first gate insulating layer on the second insulating layer side. The rubbing treatment can be usually performed by rubbing the surface of the polymer layer with paper or cloth several times in a predetermined direction. Particularly, in the present invention, it is preferable that the rubbing treatment is carried out using a method described in "Handbook of Liquid Crystal" (publishing office: MARUZEN Co., Ltd., published on October 30, 2000, pp. 226 to 229).

When the surface of the first gate insulating layer on the second gate insulating layer side is subjected to an alignment treatment, a polymerizable liquid crystalline compound which becomes the material of the second gate insulating layer described below can be aligned in accordance with the alignment treatment.

<Second gate insulating layer>

The second gate insulating layer is formed using one or two or more polymerizable (having a polymerizable group) liquid crystalline compounds. The second gate insulating layer is a layer formed by polymerizing the polymerizable liquid crystalline compound aligned in accordance with the alignment treatment performed on the surface of the first gate insulating layer in a state in which the aligned state thereof is held. The aligned state of the liquid crystalline compound is immobilized (in other words, polymerized and immobilized) due to this polymerization reaction.

In the present specification, the expression "the liquid crystalline compound is polymerized and immobilized in the aligned state" means that alignment of the polymerizable liquid crystalline compound is in a state in which the alignment thereof is stably held due to the polymerization reaction. When the liquid crystalline compound is polymerized and immobilized in the aligned state, the polymerized and immobilized liquid crystalline compound does not exhibit fluidity typically in a temperature range of 0°C to 100°C and the immobilized aligned state can be stably maintained even when an external field or an external force is applied thereto. In addition, when the polymerizable liquid crystalline compound is polymerized and immobilized in the aligned state, the polymerizable liquid crystalline compound no longer

exhibits liquid crystallinity.

- Polymerizable liquid crystalline compound -

A polymerizable liquid crystalline compound has a structure in which a polymerizable group is introduced to a liquid crystalline compound. The polymerizable group is not particularly limited. For example, a cyclic ether group such as an ethylenically unsaturated group (that is, the ethylenically unsaturated group indicates a group having an ethylene bond (carbon-carbon double bond) consumed in measurement of the bromine value or the iodine value, and does not indicate an unsaturated group exhibiting aromaticity such as benzene), an epoxy group, or an oxetane group can be widely employed as a polymerizable group. It is preferable that an ethylenically unsaturated group is introduced as an acryloyl group, a methacryloyl group, an acrylamide group, a vinyl group, or a styryl group. The number of polymerizable groups included in a polymerizable liquid crystalline compound is not particularly limited. For example, a liquid crystalline compound having 1 to 6 polymerizable groups in a molecule can be used. The number of polymerizable groups in a molecule of a polymerizable liquid crystalline compound is more preferably in a range of 1 to 5 and still more preferably in a range of 1 to 3.

The polymerizable liquid crystalline compound used in the present invention may be a discotic liquid crystalline compound (also referred to as a discotic liquid crystalline compound) or a rod-like liquid crystalline compound.

(Discotic liquid crystalline compound)

In the present invention, a polymerizable discotic liquid crystalline compound can be used for formation of the second gate insulating layer. As the polymerizable discotic liquid crystalline compound, a compound having a form in which a polymerizable group is introduced to a known discotic liquid crystalline compound of the related art can be used. The discotic liquid crystalline compound is described in various literatures (C. Destrade et al., Mol. Crysr. Liq. Cryst., vol. 71, page 111 (1981); edited by the Chemical Society of Japan, Quarterly Chemical Review, No. 22, liquid crystal chemistry, chapter 5, section 2 of chapter 10 (1994); B. Kohne et al., Angew. Chem. Soc. Chem. Comm., page 1794 (1985); J. Zhang et al., J. Am. Chem. Soc., vol. 116, page 2655 (1994)). Polymerization of the discotic liquid crystalline compound is described in JP1996-27284A (JP-H08-27284A).

Specific examples of the discotic liquid crystalline compound having a polymerizable group, which can be preferably used in the present invention, include compounds in which X represents a group having a polymerizable group among compounds (1,3,5-substituted benzene type discotic liquid crystalline compound) described in paragraphs [0038] to [0069] of JP2009-97002A. Further, compounds having a polymerizable group as a substituent among compounds described in paragraphs [0062] to [0067] of JP2007-108732A can be preferably used in the present invention as the discotic liquid crystalline compound having a polymerizable group.

(Rod-like liquid crystalline compound)

In the present invention, a polymerizable rod-like liquid crystalline compound can be used to form the second gate insulating layer, as a polymerizable liquid crystalline compound. As the polymerizable rod-like liquid crystalline compound, a compound obtained by introducing a polymerizable group to a known rod-like liquid crystalline compound of the related art can be used. Preferred examples of the rod-like liquid crystalline compound include azomethines, azoxys, cyanobiphenyls, cyanophenyl esters, benzoic acid esters, cyclohexane carboxylic acid phenyl esters, cyanophenyl cyclohexanes, cyano-substituted phenyl pyrimidines, alkoxy-substituted phenyl pyrimidines, phenyl dioxanes, tolanes, and alkenyl cyclohexyl benzonitriles. In the polymerizable rod-like liquid crystalline compound, the number of polymerizable groups in a molecule is preferably in a range of 1 to 6 and more preferably in a range of 1 to 3. As the polymerizable rod-like liquid crystalline compound, for example, compounds described in Makromol. Chem., vol. 190, pp. 2255 (1989), Advanced Materials, vol. 5, pp. 107 (1993), US4683327A, US5622648A, US5770107A, WO95/22586A, WO95/24455A, WO97/00600A, WO98/23580A, WO98/52905A, JP1989-272551A (JP-H01-272551A), JP1994-16616A (JP-H06-16616A), JP1995-110469A (JP-H07-110469A), JP1998-80081A (JP-H11-80081A), and JP2001-328973A can be used.

On the first gate insulating layer or at least the surface of the second gate insulating layer on a side on which an organic semiconductor layer is formed, it is preferable that the molecular alignment direction of the polymerizable liquid crystalline compound is any one of the vertical alignment, horizontal alignment, and oblique alignment and the aligned state is immobilized due to a polymerization reaction (that is, on the surface of the second gate insulating layer of the OTFT on the organic semiconductor side, it is preferable that the alignment direction of the polymerized and immobilized liquid crystalline compound is the vertical alignment, horizontal alignment, or oblique alignment). In the second gate insulating layer, the alignment direction of the polymerized and immobilized liquid crystalline compound may or may not be uniform in a space between the surface of the second gate insulating layer on the first insulating

layer side to the surface thereof on the organic semiconductor layer side. Typically, the alignment direction of the polymerized and immobilized liquid crystalline compound is uniform in a space from the second gate insulating layer on the first insulating layer side to the second gate insulating layer on the organic semiconductor layer side.

In the present specification, a polymerizable liquid crystalline compound or a polymerized and immobilized liquid crystalline compound being "vertically aligned" means that the polymerizable liquid crystalline compound or the polymerized liquid crystalline compound is aligned at an average inclination angle of 80° to 90° with respect to the surface of the second gate insulating layer on the organic semiconductor layer side.

In addition, in the present specification, a polymerizable liquid crystalline compound or a polymerized liquid crystalline compound being "horizontally aligned" means that the polymerizable liquid crystalline compound or the polymerized liquid crystalline compound is aligned at an average inclination angle of 0° to 10° with respect to the surface of the second gate insulating layer on the organic semiconductor layer side.

In addition, in the present specification, a polymerizable liquid crystalline compound or a polymerized liquid crystalline compound being "obliquely aligned" means that the polymerizable liquid crystalline compound or the polymerized liquid crystalline compound is aligned at an average inclination angle of greater than 10° and less than 80° with respect to the surface of the second gate insulating layer on the organic semiconductor layer side.

In a case of the discotic liquid crystalline molecule, the "average inclination angle" in the present specification indicates an average angle between the disc surface and the surface of the second gate insulating layer on the organic semiconductor layer side. In a case of the rod-like liquid crystalline molecule, the "average inclination angle" in the present specification indicates an average angle between the long axis direction of the rod-like liquid crystalline molecule and the surface of the second gate insulating layer on the organic semiconductor layer side. The minimum value of the average inclination angle is 0° and the maximum value thereof is 90°. The above-described "average angle" can be calculated by fitting incident angle dependence from two directions of the slow axis and the fast axis of retardation using ellipsometry.

In a case where the polymerizable liquid crystalline compound is a rod-like liquid crystalline compound, it is preferable that a liquid crystal phase of the polymerizable liquid crystalline compound on the first gate insulating layer becomes a nematic phase or a smectic phase during when the second gate insulating layer is formed and the alignment state thereof is immobilized due to the polymerization reaction.

Further, in a case where the polymerizable liquid crystalline compound is a discotic liquid crystalline compound, it is preferable that a liquid crystal phase of the polymerizable liquid crystalline compound on the first gate insulating layer becomes a discotic nematic phase during when the second gate insulating layer is formed and the alignment state thereof is immobilized due to the polymerization reaction.

The molecular weight of the polymerizable liquid crystalline compound used in the present invention is preferably in a range of 400 to 3000 and more preferably in a range of 600 to 2000.

A liquid crystal alignment layer may be formed of only one layer or may be a laminate of two or more layers.

The second gate insulating layer may contain components derived from materials forming the second gate insulating layer, for example, an air interface alignment control agent, a cissing inhibitor, a polymerization initiator, and a polymerizable monomer, in addition to a polymer of a liquid crystalline compound.

The second gate insulating layer can be formed by preparing a coating solution in which various materials (the above-described polymerizable liquid crystalline compound, an air interface alignment control agent, a cissing inhibitor, a polymerization initiator, and a polymerizable monomer) for forming the second gate insulating layer are dissolved or dispersed in a solvent, coating the surface of the first gate insulating layer subjected to the alignment treatment with the coating solution, heating the surface so that the polymerizable liquid crystalline compound is aligned in accordance with the alignment treatment of the first gate insulating layer, and polymerizing and immobilizing the aligned polymerizable liquid crystalline compound at the same time with the alignment or after the alignment. The components other than the polymerizable liquid crystalline compound, which can form the above-described coating solution, are described below.

- Air interface alignment control agent -

The polymerizable liquid crystalline compound can be more efficiently obliquely aligned, vertically aligned, or horizontally aligned on the surface of the second gate insulating layer on the organic semiconductor layer side by selecting a combination of an additive unevenly distributed on the air interface (surface on a side on which the organic semiconductor layer is formed) and the polymerizable liquid crystalline compound constituting the second gate insulating layer.

A known air interface alignment control agent of the related art can be used as the air interface alignment control agent. Among examples thereof, a compound having one or more substituted or unsubstituted aliphatic groups having 6 to 40 carbon atoms or substituted or unsubstituted aliphatic-substituted oligosiloxanoxy groups having 6 to 40 carbon atoms in a molecule is preferable and a compound having two or more substituted or unsubstituted aliphatic groups having 6 to 40 carbon atoms or substituted or unsubstituted aliphatic-substituted oligosiloxanoxy groups having 6 to 40 carbon atoms in a molecule is more preferable. The air interface alignment control agent which can be used in

the present invention is described in, for example, JP1999-352328A (JP-H11-352328A) or JP2002-20363A. Further, a surfactant can be used as the air interface alignment control agent. Examples of the surfactant include known surfactants of the related art. Among known surfactants, a fluorine-based compound is particularly preferable. Specifically, compounds described in paragraphs [0028] to [0056] of JP2001-330725A and compounds described in paragraphs [0100] to [0118] of JP2005-179636A may be exemplified.

The content of the air interface alignment control agent in the coating solution is not particularly limited, but is preferably in a range of 0.2 parts by mass to 10 parts by mass, more preferably in a range of 0.2 parts by mass to 5 parts by mass, and still more preferably in a range of 0.2 parts by mass to 3 parts by mass with respect to 100 parts by mass of the polymerizable liquid crystalline compound.

- Cissing inhibitor -

A cissing inhibitor is a material for preventing cissing at the time of application of the coating solution. A compound used as a cissing inhibitor is not particularly limited unless the compound significantly inhibits a change in the inclination angle or alignment of the liquid crystalline composition of the present invention, and both of a polymer compound and a low molecular weight compound may be used. It is preferable that the cissing inhibitor is a polymer.

Examples of the polymer used as a cissing inhibitor are described in JP1996-95030A (JP-H08-95030A). Particularly preferred examples of the polymer used as a cissing inhibitor include cellulose ester. Examples of the cellulose ester include cellulose acetate, cellulose acetate propionate, hydroxy propyl cellulose, and cellulose acetate butyrate.

From the viewpoint that alignment of the polymerizable liquid crystalline compound is not inhibited, the concentration of the polymer, used to prevent cissing, in the coating solution is preferably in a range of 0.1% by mass to 10% by mass, more preferably in a range of 0.1% by mass to 8% by mass, and still more preferably in a range of 0.1% by mass to 5% by mass.

Moreover, a surfactant can be used as a cissing inhibitor. Examples of the surfactant include known surfactants of the related art. Among known surfactants, a fluorine-based compound is particularly preferable. Specifically, compounds described in paragraphs [0028] to [0056] of JP2001-330725A and compounds described in paragraphs [0100] to [0118] of JP2005-179636A may be exemplified. The cissing inhibitor can serve as an air interface alignment control agent. The concentration of the surfactant in the coating solution is preferably in a range of 0.005% by mass to 8% by mass and more preferably in a range of 0.05% by mass to 2.5% by mass.

- Polymerization initiator -

A polymerization initiator can be suitably selected in consideration of the target polymerization reaction, and, for example, a photopolymerization initiator or a thermal polymerization initiator can be used. As these polymerization initiators, known compounds of the related art can be used. Since it is preferable to employ a photopolymerization reaction as the polymerization reaction, as described below, for the purpose of preventing deformation or degeneration of a substrate or the like due to heat, a photopolymerization initiator is preferably used as the polymerization initiator to be used. Examples of the photopolymerization initiator include a radical polymerization initiator and a photo-cationic polymerization initiator. A radical polymerization initiator is preferably used in a case where the polymerizable group included in a liquid crystalline compound is an ethylenically unsaturated group. Further, a photo-cationic polymerization initiator (preferably the above-described photoacid generator) is preferably used in a case where the polymerizable group included in a liquid crystalline compound is an epoxy group, an oxetane group, or a methylol group. In the present invention, a radical polymerization initiator is more preferable.

Examples of the photopolymerization initiator include an $\alpha$-carbonyl compound (such as an $\alpha$-carbonyl compound described in each specification of US2367661A and US2367670A), acyloin ether (such as acryloin ether described in the specification of US2448828A), an $\alpha$-hydrocarbon-substituted aromatic acyloin compound (such as an $\alpha$-hydrocarbon-substituted aromatic acyloin compound described in the specification of US2722512A), a polynuclear quinone compound (such as a polynuclear quinone compound described in each specification of US3046127A and US2951758A), a combination of a triaryl imidazole dimer and p-aminophenyl ketone (such as a combination of a triaryl imidazole dimer and p-aminophenyl ketone described in the specification of US3549367A), an acridine and phenazine compound (such as an acridine and phenazine compound described in JP1985-105667A (JP-S60-105667A) and US4239850A), and an oxadiazole compound (an oxadiazole compound described in the specification of US4212970A).

The use amount of the photopolymerization initiator in the coating solution is preferably in a range of 0.01% by mass to 20% by mass and more preferably in a range of 0.5% by mass to 5% by mass with respect to the solid content in the coating solution.

- Polymerizable monomer -

The above-described coating solution used to form the second gate insulating layer may contain a polymerizable monomer. The polymerizable monomer is not particularly limited as long as the polymerizable monomer has compatibility with the polymerizable liquid crystalline monomer and alignment of the polymerizable liquid crystalline monomer is not significantly inhibited. In order to more effectively immobilize the alignment state of the liquid crystalline compound, a compound having an ethylenically unsaturated group exhibiting polymerization activity such as a vinyl group, a vinyloxy group, an acryloyl group, or a methacryloyl group is preferably used. The content of the polymerizable monomer in the coating solution is preferably in a range of 0.5% by mass to 50% by mass and more preferably in a range of 1% by mass to 30% by mass with respect to 100% by mass of the polymerizable liquid crystalline compound in the coating solution. Moreover, since an effect of improving solvent resistance can be expected, it is particularly preferable that a monomer having two or more polymerizable groups is used. The number of polymerizable groups included in one molecule of a polymerizable monomer is preferably in a range of 2 to 6 and more preferably in a range of 2 to 4.

The molecular weight of the polymerizable monomer is preferably in a range of 100 to 600 and more preferably in a range of 150 to 400.

- Coating solvent -

As a solvent used for the coating solution that is used to form the second gate insulating layer, an organic solvent is preferably used. Examples of the organic solvent include an amide (such as N,N-dimethylformamide), a sulfoxide (such as dimethyl sulfoxide), a heterocyclic compound (such as pyridine), a hydrocarbon (such as toluene or hexane), an alkyl halide (such as chloroform or dichloromethane), an ester (such as methyl acetate or butyl acetate), a ketone (such as acetone, methyl ethyl ketone, methyl isobutyl ketone, or cyclohexanone), and an ether (such as tetrahydrofuran or 1,2-dimethoxyethane). Among these, an alkyl halide, an ester, and a ketone are preferable. For the coating solution, a combination of two or more organic solvents may be used.

- Coating method -

The second gate insulating layer is formed by firstly preparing a coating solution for forming the second gate insulating layer, coating the first gate insulating layer whose surface is subjected to the alignment treatment with this coating solution, and aligning the polymerizable liquid crystalline compound. The surface is coated with the coating solution according to a known method (such as a spin coating method, a wire bar coating method, an extrusion coating method, a direct gravure coating method, a reverse gravure coating method, or a die coating method).

- Alignment of polymerizable liquid crystalline compound -

The polymerizable liquid crystalline compound can be aligned by coating the surface with the coating solution and then heating the surface to a liquid crystal temperature range. The liquid crystal temperature range is preferably 50°C to 200°C and more preferably 70°C to 150°C. In a case where the liquid crystal temperature range is high, the temperature can be adjusted using the amount of various materials to be added.

[Polymerization method]

After the polymerizable liquid crystalline compound is aligned in accordance with the alignment treatment applied to the surface of the first gate insulating layer, the polymerizable liquid crystalline compound (a polymerizable liquid crystalline compound and a polymerizable monomer in a case where the coating solution for forming the second gate insulating layer contains a polymerizable monomer in addition to a polymerizable liquid crystalline compound) is polymerized to immobilize the alignment state. Examples of the polymerization reaction include a thermal polymerization reaction using a thermal polymerization initiator, a photopolymerization reaction using a photopolymerization initiator, and a polymerization reaction generated by performing irradiation with electron beams. Among these, in order to prevent deformation or deterioration of a support or the like caused by heat, a photopolymerization reaction or a polymerization reaction generated by performing irradiation with electron beams is preferable and a photopolymerization reaction is more preferable. As the photopolymerization reaction, a radical polymerization reaction or a cationic polymerization reaction is preferable and a radical polymerization reaction is more preferable.

It is preferable to use ultraviolet rays for irradiation with light for the purpose of polymerization. The irradiation energy (integration) is preferably in a range of 0.01 $J/cm^2$ to 50 $J/cm^2$ and more preferably in a range of 0.05 $J/cm^2$ to 0.8 $J/cm^2$. In order to accelerate the photopolymerization reaction, irradiation with light may be carried out under the condition of heating. Further, since the oxygen concentration in the atmosphere affects the degree of polymerization, in

a case where the degree of polymerization does not reach a desired degree of polymerization in air, it is preferable that the oxygen concentration is lowered according to a method of nitrogen concentration or the like. The concentration of oxygen in the atmosphere in which the polymerization reaction occurs is preferably 10% or less, more preferably 7% or less, and most preferably 3% or less. The temperature of the photopolymerization reaction is preferably in a range of 40°C to 150°C and more preferably in a range of 60°C to 100°C.

[Organic semiconductor layer]

An organic semiconductor layer is a layer which exhibits properties of a semiconductor and on which carriers can be accumulated.

The organic semiconductor layer may contain an organic semiconductor.

The organic semiconductor is not particularly limited, and examples thereof include an organic polymer, a derivative thereof, and a low molecular weight compound.

In the present invention, the low molecular weight compound indicates a compound other than an organic polymer and a derivative thereof, that is, a compound that does not have a repeating unit. As long as the low molecular weight compound is such a compound, the molecular weight thereof is not particularly limited. The molecular weight of the low molecular weight compound is preferably in a range of 300 to 2000 and more preferably in a range of 400 to 1000.

As the low molecular weight compound, a condensed polycyclic aromatic compound may be exemplified. Examples thereof include acene such as naphthacene, pentacene(2,3,6,7-dibenzoanthracene), hexacene, heptacene, dibenzopentacene, or tetrabenzopentacene, anthradithiophene, pyrene, benzopyrene, dibenzopyrene, chrysene, perylene, coronene, terrylene, ovalene, quaterrylene, circumanthracene, a derivative in which some of these carbon atoms are substituted with atoms such as N, S, and O, a derivative (a dioxa anthanthrene-based compound including perixanthenoxanthene and a derivative thereof, triphenodioxazine, triphenodithiazine, or hexacene-6,15-quinone) in which at least one hydrogen atom bonded to the carbon atom is substituted with a functional group such as a carbonyl group, and a derivative in which the hydrogen atom is substituted with another functional group.

Further, other examples thereof include metal phthalocyanine represented by copper phthalocyanine, tetrathiapentalene and a derivative thereof, naphthalene tetracarboxylic acid diimide such as naphthalene-1,4,5,8-tetracarboxylic acid diimide, N,N'-bis(4-trifluoromethylbenzyl)naphthalene-1,4,5,8-tetracarboxylic acid diimide, N,N'-bis(1H,1H-perfluorooctyl), N,N'-bis(1H,1H-perfluorobutyl), a N,N'-dioctylnaphthalene-1,4,5,8-tetracarboxylic acid diimide derivative, or naphthalene-2,3,6,7-tetracarboxylic acid diimide, condensed ring tetracarboxylic acid diimide, for example, anthracene tetracarboxylic acid diimide such as anthracene-2,3,6,7-tetracarboxylic acid diimide, fullerene such as C60, C70, C76, C78, or C84 and a derivative of these, a carbon nanotube such as SWNT, and dyes such as a merocyanine dye and a hemicyanine dye and a derivative of these.

Moreover, polyanthracene, triphenylene, and quinacridone are also exemplified.

In addition, examples of the low molecular weight compound include 4,4'-biphenyl dithiol (BPDT), 4,4'-diisocyanobiphenyl, 4,4'-diisocyano-p-terphenyl, 2,5-bis(5'-thioacetyl-2'-thiophenyl)thiophene, 2,5-bis(5'-thioacetoxyl-2'-thiophenyl)thiophene, 4,4'-diisocyanophenyl, benzidine(biphenyl-4,4'-diamine), tetracyanoquinodimethane (TCNQ), tetrathiafulvalene (TTF) and a derivative thereof, a tetrathiafulvalene (TTF)-TCNQ complex, a bisethylene tetrathiafulvalene (BEDTTTF)-perchloric acid complex, a BEDTTTF-iodine complex, a charge transfer complex represented by a TCNQ-iodine complex, biphenyl-4,4'-dicarboxylic acid, 1,4-di(4-thiophenylacetylenyl)-2-ethylbenzene, 1,4-di(4-isocyanophenylacetylenyl)-2-ethylbenzene, 1,4-di(4-thiophenylethynyl)-2-ethylbenzene, 2,2''-dihydroxy-1,1':4',1''-terphenyl, 4,4'-biphenyl diethanal, 4,4'-biphenyl diol, 4,4'-biphenyl diisocyanate, 1,4-diacetynylbenzene, diethylbiphenyl-4,4'-dicarboxylate, benzo[1,2-c;3,4-c';5,6-c'']tris[1,2]dithiol-1,4,7-trithione, α-sexithiophene, tetrathiatetracene, tetraselenotetracene, tetratellurium tetracene, poly(3-alkylthiophene), poly(3-thiophene-β-ethanesulfonic acid), poly(N-alkylpyrrole), poly(3-alkylpyrrole), poly(3,4-dialkylpyrrole), poly(2,2'-thienylpyrrole), and poly(dibenzothiophene sulfide).

It is preferable that the organic semiconductor is a low molecular weight compound. Among examples thereof, a condensed polycyclic aromatic compound is preferable. The condensed polycyclic aromatic compound is highly effective in improving carrier mobility and durability and exhibits an excellent effect of decreasing the threshold voltage.

As the condensed polycyclic aromatic compound, acene represented by any of Formulae (A1) to (A4) and a compound represented by any of the following Formulae (C) to (T) are preferable, and a compound represented by any of the following Formulae (C) to (T) is more preferable from the viewpoint of being easily unevenly distributed together with the resin (C).

The acene which is preferable as the condensed polycyclic aromatic compound is represented by the following Formula (A1) or (A2).

Formula (A1)

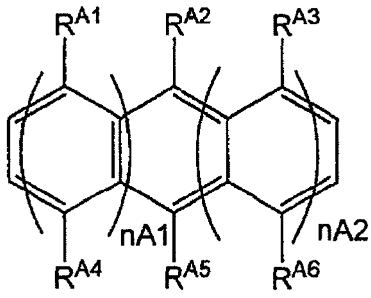

Formula (A2)

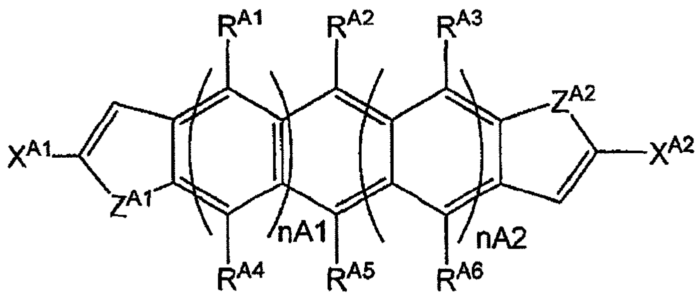

In Formulae, $R^{A1}$ to $R^{A6}$ and $X^{A1}$ and $X^{A2}$ represent a hydrogen atom or a substituent. $Z^{A1}$ and $Z^{A2}$ represent S, O, Se, or Te.

nA1 and nA2 represent an integer of 0 to 3. In this case, nA1 and nA2 do not represent 0 at the same time.

The substituent respectively represented by $R^{A1}$ to $R^{A6}$ and $X^{A1}$ and $X^{A2}$ is not particularly limited, and examples thereof include an alkyl group (such as methyl, ethyl, propyl, isopropyl, tert-butyl, pentyl, tert-pentyl, hexyl, octyl, tert-octyl, dodecyl, tridecyl, tetradecyl, or pentadecyl), a cycloalkyl group (such as cyclopentyl or cyclohexyl), an alkenyl group (such as vinyl, allyl, 1-propenyl, 2-butenyl, 1,3-butadienyl, 2-pentenyl, or isopropenyl), an alkynyl group (such as ethynyl or propargyl), an aromatic hydrocarbon group (also referred to as an aromatic carbocyclic group or an aryl group, and examples thereof include phenyl, p-chlorophenyl, mesityl, tolyl, xylyl, naphthyl, anthryl, azulenyl, acenaphthenyl, fluorenyl, phenanthryl, indenyl, pyrenyl, and biphenylyl), an aromatic heterocyclic group (also referred to as a heteroaryl group, and examples thereof include a pyridyl group, a pyrimidinyl group, a furyl group, a pyrrolyl group, an imidazolyl group, a benzoimidazolyl group, a pyrazolyl group, a pyrazinyl group, a triazolyl group (such as a 1,2,4-triazol-1-yl group or a 1,2,3-triazol-1-yl group), an oxazolyl group, a benzoxazolyl group, a thiazolyl group, an isoxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolinyl group, a diazacarbazolyl group (a group in which one carbon atom constituting a carboline ring of a carbolinyl group is replaced with a nitrogen atom), a quinoxalinyl group, a pyridazinyl group, a triazinyl group, a triazinyl group, a quinazolinyl group, and a phthalazinyl group), a heterocyclic group (also referred to as a heteroaryl ring group, and examples thereof include a pyrrolidyl group, an imidazolidyl group, a morpholyl group, and an oxazolidyl group), an alkoxy group (such as methoxy, ethoxy, propyloxy, pentyloxy, hexyloxy, octyloxy, or dodecyloxy), a cycloalkoxy group (such as cyclopentyloxy or cyclohexyloxy), an aryloxy group (such as phenoxy or naphthyloxy), an alkylthio group (such as methylthio, ethylthio, propylthio, pentylthio, hexylthio, octylthio, or dodecylthio), a cycloalkylthio group (such as cyclopentylthio or cyclohexylthio), an arylthio group (such as phenylthio or naphthylthio), an alkoxycarbonyl group (such as methyloxycarbonyl, ethyloxycarbonyl, butyloxycarbonyl, octyloxycarbonyl, or dodecyloxycarbonyl), an aryloxycarbonyl group (such as phenyloxycarbonyl or naphthyloxycarbonyl), a sulfamoyl group (such as aminosulfonyl, methylaminosulfonyl, dimethylaminosulfonyl, butylaminosulfonyl, hexylaminosulfonyl, cyclohexylaminosulfonyl, octylaminosulfonyl, dodecylaminosulfonyl, phenylaminosulfonyl, naphthylaminosulfonyl, or 2-pyridylaminosulfonyl), an acyl group (such as acetyl, ethylcarbonyl, propylcarbonyl, pentylcarbonyl, cyclohexylcarbonyl, octylcarbonyl, 2-ethylhexylcarbonyl, dodecylcarbonyl, phenylcarbonyl, naphthylcarbonyl, or pyridylcarbonyl), an acyloxy group (such as acetyloxy, ethylcarbonyloxy, butylcarbonyloxy, octylcarbonyloxy, or dodecylcarbonyloxy, phenylcarbonyloxy), an amide group (such as methylcarbonylamino, ethylcarbonylamino, dimethylcarbonylamino, propylcarbonylamino, pentylcarbonylamino, cyclohexylcarbonylamino, 2-ethylhexylcarbonylamino, octylcarbonylamino, dodecylcarbonylamino, phenylcarbonylamino, or naphthylcarbonylamino), a carbamoyl group (such as aminocarbonyl, methylaminocarbonyl, dimethylaminocarbonyl, propylaminocarbonyl, pentylaminocarbonyl, cyclohexylaminocarbonyl, octylaminocarbonyl, 2-ethylhexylaminocarbonyl, dodecylaminocarbonyl, phenylaminocarbonyl, naphthylaminocarbonyl, naphthylaminocarbonyl, or 2-pyridylaminocarbonyl), an ureido group (such as methylureido, ethylureido, pentylureido, cyclohexylureido, octylureido, dodecylureido, phenylureido, naphthylureido, or 2-pyridylaminoureido), a sulfinyl group (such as methylsulfinyl, ethylsulfinyl, butylsulfinyl, cyclohexylsulfinyl, 2-ethylhexylsulfinyl, dodecylsulfinyl, phenylsulfinyl, naphthylsulfinyl, or 2-pyridylsulfinyl), an alkylsulfonyl group (such as methylsulfonyl, ethylsulfonyl, butylsulfonyl, cyclohexylsulfonyl, 2-ethylhexylsulfonyl, or dodecylsulfonyl), an arylsulfonyl group (such as phenylsulfonyl, naphthylsulfonyl, or 2-pyridylsulfonyl), an amino group (such as amino, ethylamino, dimethylamino, butylamino, cyclopentylamino, 2-ethylhexylamino, dodecylamino, anilino, naphthylamino, or 2-pyridylamino), a halogen atom (such as a fluorine atom, a chlorine atom, or a bromine atom), a fluorinated hydrocarbon group (such as fluoromethyl, trifluoromethyl, pentafluoroethyl, or pentafluorophenyl), a cyano group, a nitro group, a hydroxyl group, a mercapto group, a silyl group (such as trimethylsilyl, triisopropylsilyl, triphenylsilyl, or phenyldiethylsilyl), and a group (in this case, $X^A$

represents Ge or Sn) represented by the following Formula (SG1).

These substituents may further include a plurality of substituents. As the plurality of substituents which may be included in these substituents, substituents represented by $R^{A1}$ to $R^{A6}$ are exemplified.

Among the above-described examples of acene, one represented by the following Formula (A3) or (A4) is preferable.

Formula (A3)

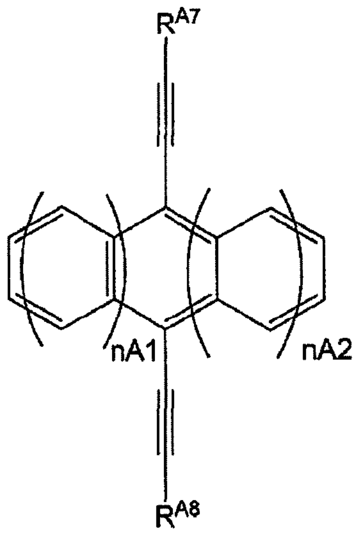

Formula (A4)

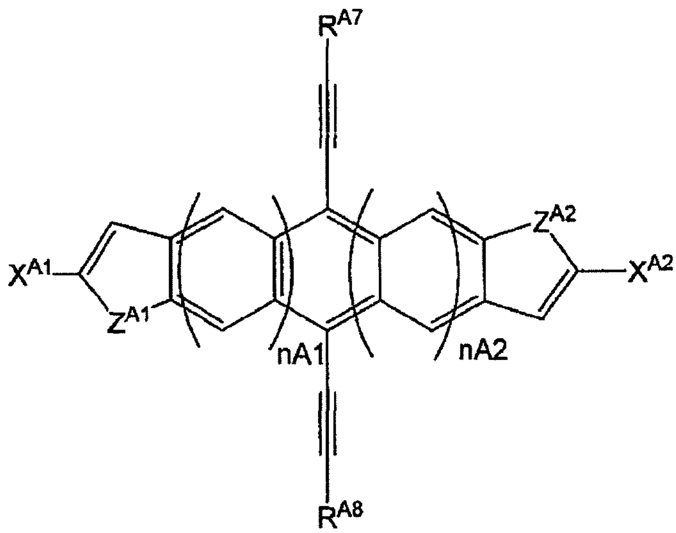

In the formulae, $R^{A7}$, $R^{A8}$, $X^{A1}$, and $X^{A2}$ represent a hydrogen atom or a substituent. $R^{A7}$, $R^{A8}$, $X^{A1}$, and $X^{A2}$ may be the same as or different from each other. Preferred examples of the substituents represented by $R^{A7}$ and $R^{AA}$ include those exemplified as the substituents which may be employed as $R^{A1}$ to $R^{A6}$ in Formulae (A1) and (A2).

$Z^{A1}$ and $Z^{A2}$ represent S, O, Se, or Te.

nA1 and nA2 represent an integer of 0 to 3. In this case, nA1 and nA2 do not represent 0 at the same time.

In Formula (A3) or (A4), it is preferable that $R^{A7}$ and $R^{A8}$ are represented by the following Formula (SG1).

Formula (SG1)

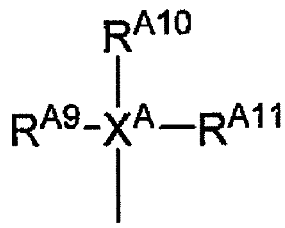

In the formula, $R^{A9}$ to $R^{A11}$ represent a substituent. $X^A$ represents Si, Ge, or Sn. Preferred examples of the substituents represented by $R^{A9}$ and $R^{A11}$ include those exemplified as the substituents which may be employed as $R^{A1}$ to $R^{A6}$ in Formulae (A1) and (A2).

Hereinafter, specific examples of acene or an acene derivative represented by Formula (A1) to (A4) will be described, but the present invention is not limited to those.

Compound A1

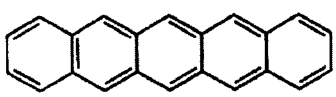

Compound A2

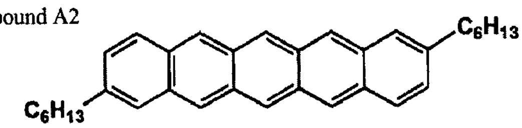

Compound A3

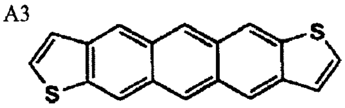

Compound A4

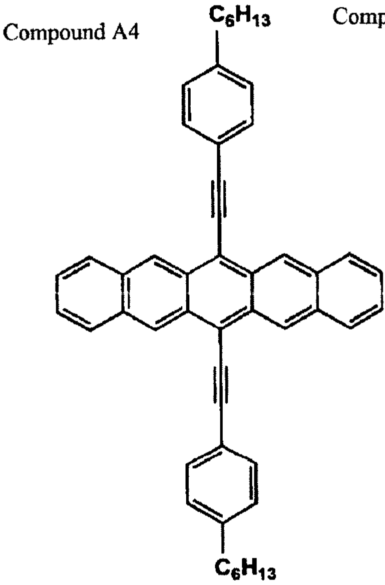

Compound A5

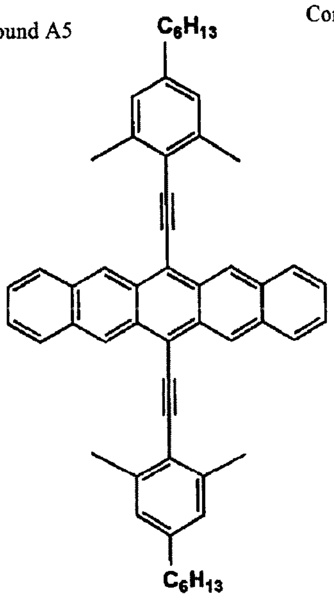

Compound A6

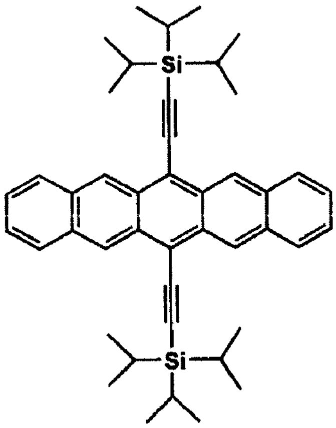

Compound A7

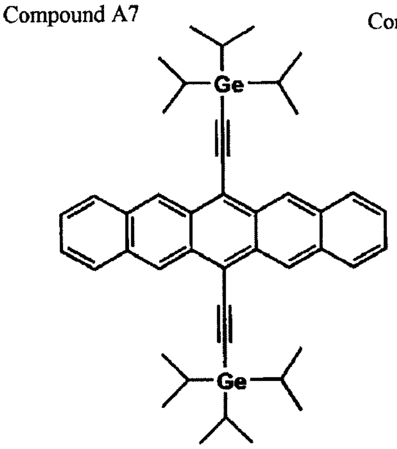

Compound A8

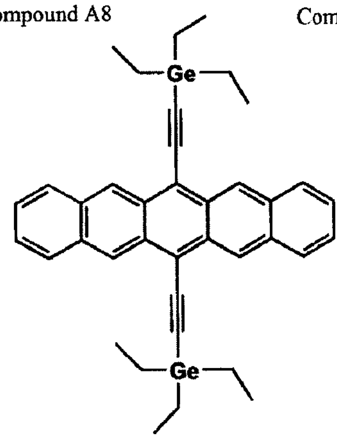

Compound A9

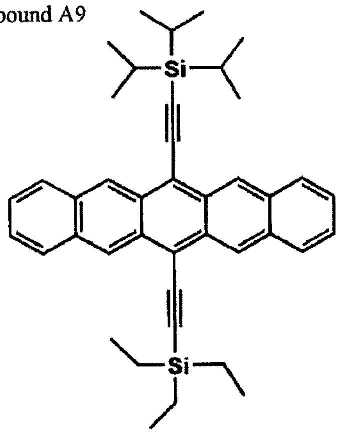

Compound A10

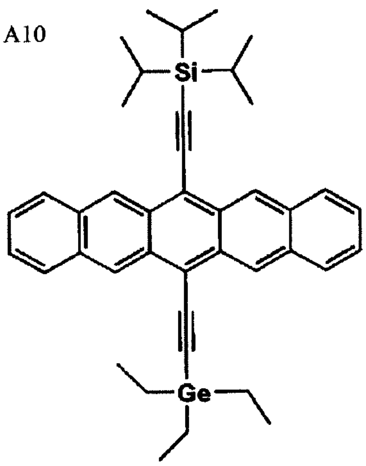

Compound A11

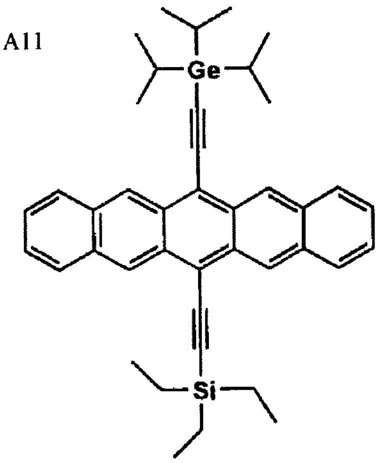

Compound A12

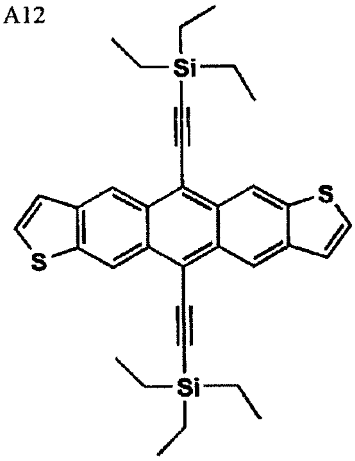

Compound A13

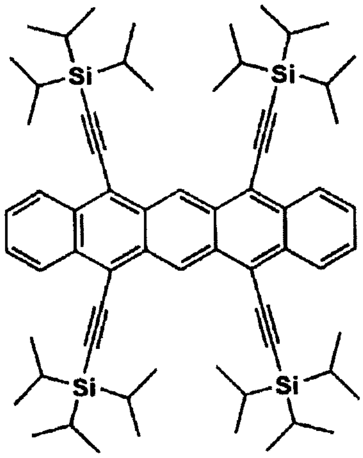

Compound A14

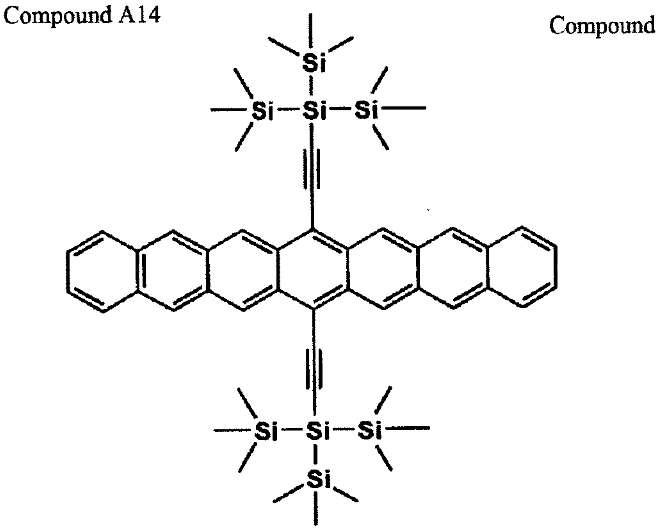

Compound A15

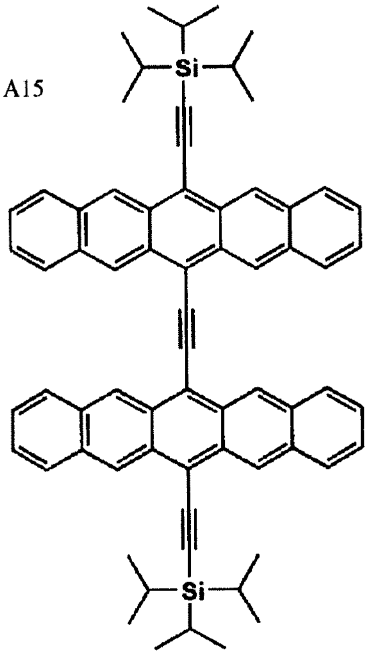

Compound A16

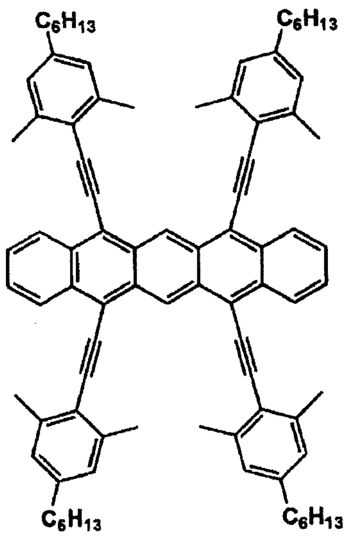

Compound A17

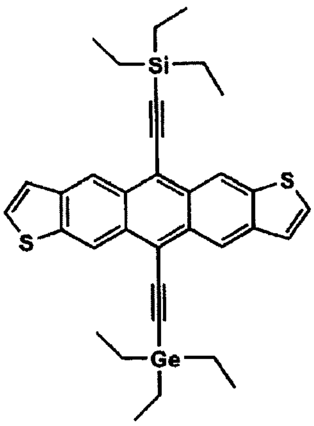

Compound A18

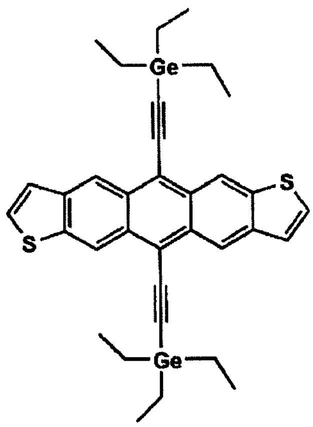

Compound A19

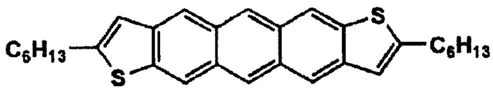

Compound A20

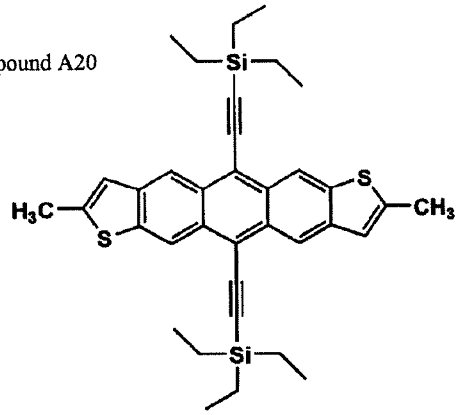

Compound A21

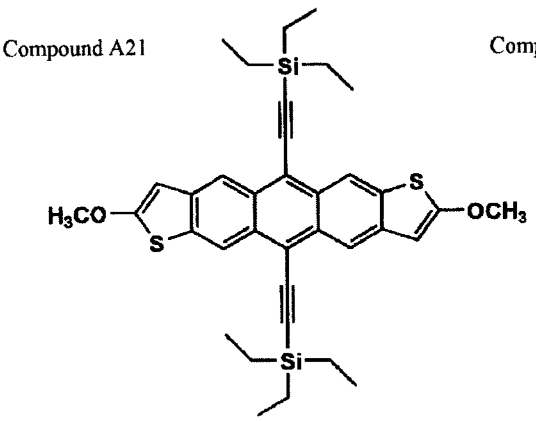

Compound A22

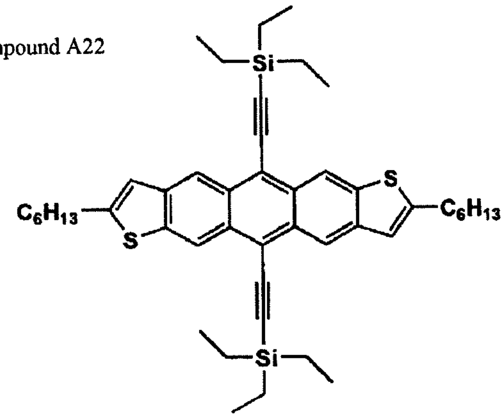

Compound A23

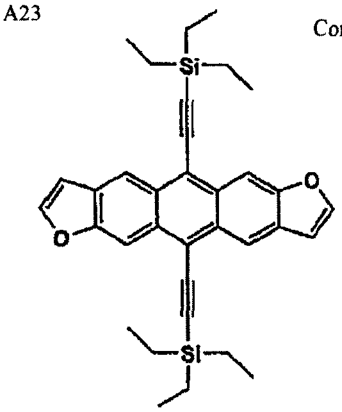

Compound A24

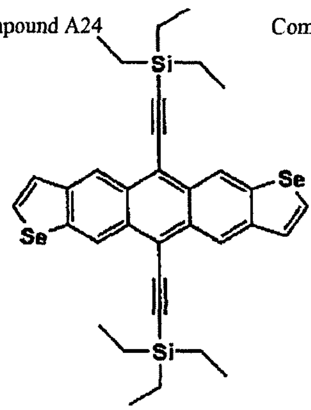

Compound A25

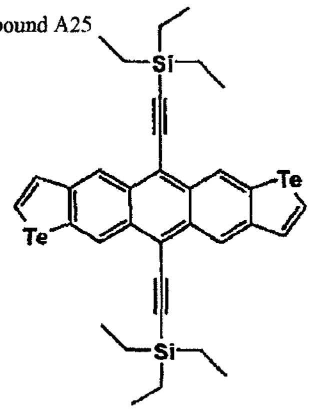

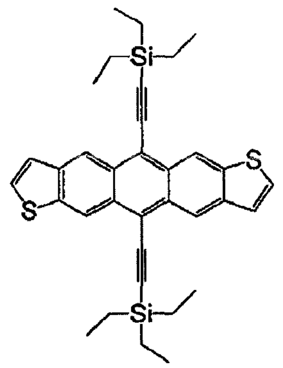

Compound A26

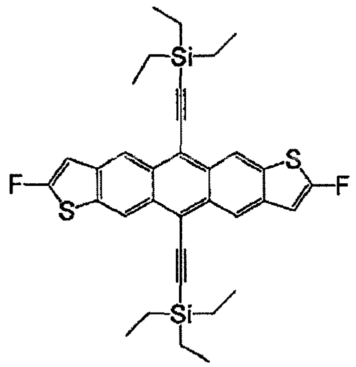

Compound A27

As the condensed polycyclic aromatic compound, compounds represented by the following Formulae (C) to (T) are also preferable.

Formula (C)

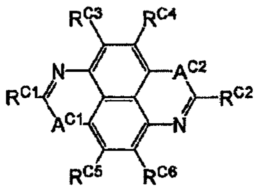

Formula (D)

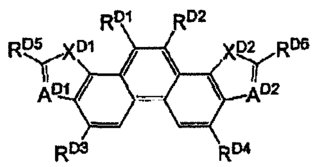

Formula (E)

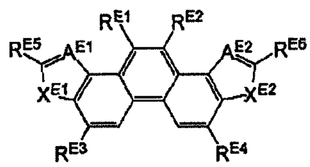

Formula (F)

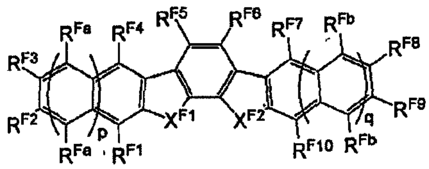

Formula (G)

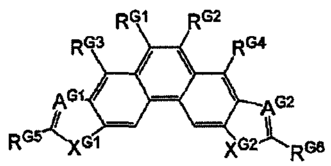

Formula (H)

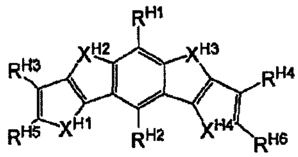

Formula (J)

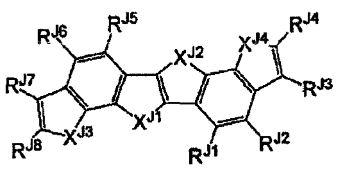

Formula (K)

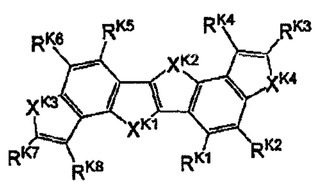

Formula (L)

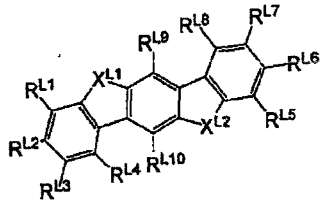

Formula (M)

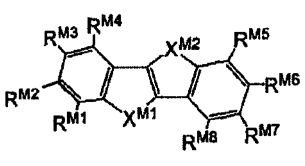

Formula (N)

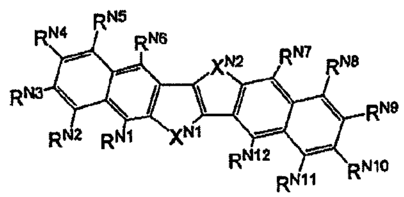

Formula (P)

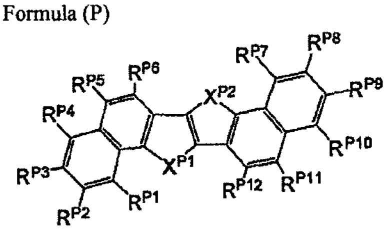

Formula (Q)

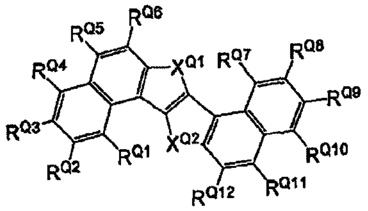

Formula (R)

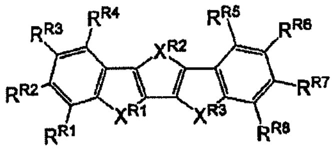

Formula (S)

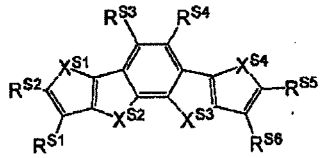

Formula (T)

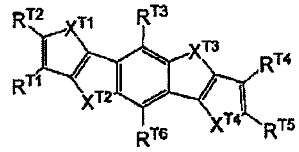

In Formula (C), $A^{C1}$ and $A^{C2}$ represent an oxygen atom, a sulfur atom, or a selenium atom. It is preferable that both of $A^{C1}$ and $A^{C2}$ represent an oxygen atom or a sulfur atom and more preferable that $A^{C1}$ and $A^{C2}$ represent a sulfur atom. $R^{C1}$ to $R^{C6}$ represent a hydrogen atom or a substituent. At least one of $R^{C1}$, ..., or $R^{C6}$ represents a substituent represented by the following Formula (W).

In Formula (D), $X^{D1}$ and $X^{D2}$ represent $NR^{D9}$, an oxygen atom, or a sulfur atom. $A^{D1}$ represents $CR^{D7}$ or a N atom, $A^{D2}$ represents $CR^{D8}$ or a N atom, and $R^{D9}$ represents a hydrogen atom, an alkyl group, an alkenyl group, an alkynyl group, or an acyl group. $R^{D1}$ to $R^{D8}$ represent a hydrogen atom or a substituent, and at least one of $R^{D1}$, ..., or $R^{D8}$ represents a substituent represented by the following Formula (W).

In Formula (E), $X^{E1}$ and $X^{E2}$ represent an oxygen atom, a sulfur atom, or $NR^{E7}$. $A^{E1}$ and $A^{E2}$ represent $CR^{E8}$ or a nitrogen atom. $R^{E1}$ to $R^{E8}$ represent a hydrogen atom or a substituent. At least one of $R^{E1}$, ..., or $R^{E8}$ represents a substituent represented by the following Formula (W).

In Formula (F), $X^{F1}$ and $X^{F2}$ represent an oxygen atom, a sulfur atom, or a selenium atom. It is preferable that $X^{F1}$ and $X^{F2}$ represent an oxygen atom or a sulfur atom and more preferable that $X^{F1}$ and $X^{F2}$ represent a sulfur atom. $R^{F1}$ to $R^{F10}$, $R^{Fa}$, and $R^{Fb}$ represent a hydrogen atom or a substituent. At least one of $R^{F1}$, ..., or $R^{F10}$, $R^{Fa}$, or $R^{Fb}$ represents a substituent represented by Formula (W). p and q represent an integer of 0 to 2.

In Formula (G), $X^{G1}$ and $X^{G2}$ represent $NR^{G9}$, an oxygen atom, or a sulfur atom. $A^{G1}$ represents $CR^{G7}$ or a N atom. $A^{G2}$ represents $CR^{G8}$ or a N atom. $R^{G9}$ represents a hydrogen atom, an alkyl group, an alkenyl group, an alkynyl group, an acyl group, an aryl group, or a heteroaryl group. $R^{G1}$ to $R^{G8}$ represent a hydrogen atom or a substituent. At least one of $R^{G1}$,..., or $R^{G8}$ represents a substituent represented by the following Formula (W).

In Formula (H), $X^{H1}$ and $X^{H4}$ represent $NR^{H7}$, an oxygen atom, or a sulfur atom. It is preferable that $X^{H1}$ to $X^{H4}$ represent a sulfur atom. $R^{H7}$ represents a hydrogen atom, an alkyl group, an alkenyl group, an alkynyl group, an acyl group, an aryl group, or a heteroaryl group. $R^{H1}$ to $R^{H6}$ represent a hydrogen atom or a substituent. At least one of $R^{H1}$, ..., or $R^{H6}$ represents a substituent represented by the following Formula (W).

In Formula (J), $X^{J1}$ and $X^{J2}$ represent an oxygen atom, a sulfur atom, a selenium atom, or $NR^{J9}$. $X^{J3}$ and $X^{J4}$ represent an oxygen atom, a sulfur atom, or a selenium atom. It is preferable that $X^{J1}$, $X^{J2}$, $X^{J3}$, and $X^{J4}$ represent a sulfur atom. $R^{J1}$ to $R^{J9}$ represent a hydrogen atom or a substituent. At least one of $R^{J1}$, ..., or $R^{J9}$ represents a substituent represented by the following Formula (W).

In Formula (K), $X^{K1}$ and $X^{K2}$ represent an oxygen atom, a sulfur atom, a selenium atom, or $NR^{K9}$. $X^{K3}$ and $X^{K4}$ represent an oxygen atom, a sulfur atom, or a selenium atom. It is preferable that $X^{K1}$, $X^{K2}$, $X^{K3}$, and $X^{K4}$ represent a sulfur atom. $R^{K1}$ to $R^{K9}$ represent a hydrogen atom or a substituent. At least one of $R^{K1}$, ..., or $R^{K9}$ represents a substituent represented by the following Formula (W).

In Formula (L), $X^{L1}$ and $X^{L2}$ represent an oxygen atom, a sulfur atom, or $NR^{L11}$. It is preferable that $X^{L1}$ and $X^{L2}$ represent an oxygen atom or a sulfur atom. $R^{L1}$ to $R^{L11}$ represent a hydrogen atom or a substituent, and at least one of $R^{L1}$, ..., or $P^{L11}$ represents a substituent represented by the following Formula (W).

In Formula (M), $X^{M1}$ and $X^{M2}$ represent an oxygen atom, a sulfur atom, a selenium atom, or $NR^{M9}$. It is preferable that $X^{M1}$ and $X^{M2}$ represent a sulfur atom. $R^{M1}$ to $R^{M9}$ represent a hydrogen atom or a substituent. At least one of $R^{M1}$, ..., or $R^{M9}$ represents a substituent represented by the following Formula (W).

In Formula (N), $X^{N1}$ and $X^{N2}$ represent an oxygen atom, a sulfur atom, a selenium atom, or $NR^{N13}$. It is preferable that $X^{N1}$ and $X^{N2}$ represent a sulfur atom. $R^{N1}$ to $R^{N13}$ represent a hydrogen atom or a substituent. At least one of $R^{N1}$, ..., or $R^{N13}$ represents a substituent represented by the following Formula (W).

In Formula (P), $X^{P1}$ and $X^{P2}$ represent an oxygen atom, a sulfur atom, a selenium atom, or $NR^{P13}$. It is preferable

that $X^{P1}$ and $X^{P2}$ represent a sulfur atom. $R^{P1}$ to $R^{P13}$ represent a hydrogen atom or a substituent. At least one of $R^{P1}$, ..., or $R^{P13}$ represents a substituent represented by the following Formula (W).

In Formula (Q), $X^{Q1}$ and $X^{Q2}$ represent an oxygen atom, a sulfur atom, a selenium atom, or $NR^{Q13}$. It is preferable that $X^{Q1}$ and $X^{Q2}$ represent a sulfur atom. $R^{Q1}$ to $R^{Q13}$ represent a hydrogen atom or a substituent. At least one of $R^{Q1}$, ..., or $R^{Q13}$ represents a substituent represented by the following Formula (W).

In Formula (R), $X^{R1}$, $X^{R2}$, and $X^{R3}$ represent an oxygen atom, a sulfur atom, a selenium atom, or $NR^{R9}$. It is preferable that $X^{R1}$, $X^{R2}$, and $X^{R3}$ represent a sulfur atom. $R^{R1}$ to $R^{R9}$ represent a hydrogen atom or a substituent. At least one of $R^{R1}$, ..., or $R^{R9}$ represents a substituent represented by the following Formula (W).

In Formula (S), $X^{S1}$, $X^{S2}$, $X^{S3}$, and $X^{S4}$ represent an oxygen atom, a sulfur atom, a selenium atom, or $NR^{S7}$. It is preferable that $X^{S1}$, $X^{S2}$, $X^{S3}$, and $X^{S4}$ represent a sulfur atom. $R^{S1}$ to $R^{S7}$ represent a hydrogen atom or a substituent. At least one of $R^{S1}$, ..., or $R^{S7}$ represents a substituent represented by the following Formula (W).

In Formula (T), $X^{T1}$, $X^{T2}$, $X^{T3}$, and $X^{T4}$ represent an oxygen atom, a sulfur atom, a selenium atom, or $NR^{17}$. It is preferable that $X^{T1}$, $X^{T2}$, $X^{T3}$, and $X^{T4}$ represent a sulfur atom. $R^{T1}$ to $R^{T7}$ represent a hydrogen atom or a substituent. At least one of $R^{T1}$, ..., or $R^{T7}$ represents a substituent represented by the following Formula (W).

Hereinafter, in Formulae (C) to (T), $R^{C1}$ to $R^{C6}$, $R^{D1}$ to $R^{D8}$, $R^{E1}$ to $R^{E8}$, $R^{F1}$ to $R^{F10}$, $R^{Fa}$ and $F^{Fb}$, $R^{G1}$ to $R^{G8}$ $R^{H1}$ to $R^{H6}$ $R^{J1}$ to $R^{J9}$, $R^{K1}$ to $R^{K9}$, $R^{L1}$ to $R^{L11}$, $R^{M1}$ to $R^{M9}$, $R^{N1}$ to $R^{N13}$, $R^{P1}$ to $R^{P13}$, $R^{Q1}$ to $R^{Q13}$, $R^{R1}$ to $R^{R9}$, $R^{S1}$ to $R^{S7,}$ and $R^{T1}$ to $R^{T7}$ (hereinafter, referred to as substituents $R^{C}$ to $R^{T}$) which represent a hydrogen atom or a substituent.

Examples of the substituent which may be employed by the substituents $R^{C}$ to $R^{T}$ include a halogen atom, an alkyl group (an alkyl group having 1 to 40 carbon atoms such as methyl, ethyl, propyl, butyl, pentyl, hexyl, heptyl, octyl, nonyl, decyl, undecyl, dodecyl, tridecyl, tetradecyl, or pentadecyl, and in this case, 2,6-dimethyloctyl, 2-decyltetradecyl, 2-hexyldodecyl, 2-ethyloctyl, 2-decyltetradecyl, 2-butyldecyl, 1-octylnonyl, 2-ethyloctyl, 2-octyltetradecyl, 2-ethylhexyl, cycloalkyl, bicycloalkyl, and tricycloalkyl are included), an alkenyl group (such as 1-pentenyl, cycloalkenyl, or bicycloalkenyl), an alkynyl group (such as 1-pentynyl, trimethylsilylethynyl, triethylsilylethynyl, tri-i-propylsilylethynyl, or 2-p-propylphenylethynyl), an aryl group (for example, an aryl group having 6 to 20 carbon atoms such as phenyl, naphthyl, p-pentylphenyl, 3,4-dipentylphenyl, p-heptoxyphenyl, or 3,4-diheptoxyphenyl), a heterocyclic group (such as a 2-hexylfuranyl group), a cyano group, a hydroxy group, a nitro group, an acyl group (such as hexanoyl or benzoyl), an alkoxy group (such as buthoxy), an aryloxy group, a silyloxy group, a heterocyclic oxy group, an acyloxy group, a carbamoyloxy group, an amino group (such as an anilino group), an acylamino group, an aminocarbonylamino group (such as an ureido group), an alkoxy aryloxycarbonylamino group, an alkyl arylsulfonylamino group, a mercapto group, an alkyl arylthio group (such as methylthio or octylthio), a heterocyclic thio group, a sulfamoyl group, a sulfo group, an alkyl arylsulfinyl group, an alkyl arylsulfonyl group, an alkyl aryloxycarbonyl group, a carbamoyl group, an aryl heterocyclic azo group, an imido group, a phosphino group, a phosphinyl group, a phosphinyloxy group, a phosphinylamino group, a phosphono group, a silyl group (such as a ditrimethylsiloxymethylbutoxy group), a hydrazino group, an ureido group, a boronic acid group ($-B(OH)_2$), a phosphate group ($-OPO(OH)_2$), a sulfato group($-OSO_3H$), and other known substituents.

These substituents may further include the above-described substituents.

Among these, as the substituents which may be employed by the substituents $R^{C}$ to $R^{T}$, an alkyl group, an aryl group, an alkenyl group, an alkynyl group, a heterocyclic group, an alkoxy group, an alkylthio group, and a group represented by the following Formula (W) are preferable, an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, and a group represented by the following Formula (W) are more preferable, a group represented by the following Formula (W) is particularly preferable, and a group represented by the following Formula (W) is more particularly preferable.

The alkyl group, the alkenyl group, the alkynyl group, the acyl group, and the aryl group as $R^{D9}$, $R^{G9}$, and $R^{H7}$ described above respectively have the same definitions as those for the alkyl group, the alkenyl group, the alkynyl group, the acyl group, and the aryl group described in the section of the substituents which may be employed by the substituents $R^{C}$ to $R^{T}$.

Moreover, the heteroaryl group has the same definition as that for the heteroaryl group described in the section of the substituents of $R^{A1}$ to $R^{A6}$.

Formula (W) describes a group represented by $-L-R^{W}$.

In Formula (W), L represents a divalent linking group represented by any of the following Formulae (L-1) to (L-25) or a divalent linking group in which two or more (preferably 2 to 10, more preferably 2 to 6, and still more preferably 2 or 3) divalent linking groups represented by any of Formulae (L-1) to (L25) are bonded to each other. $R^{W}$ represents a substituted or unsubstituted alkyl group, a cyano group, a vinyl group, an ethynyl group, an oxyethylene group, an oligooxyethylene group in which a repeating number v of oxyethylene units is 2 or greater, a siloxane group, an oligosiloxane group having 2 or more silicon atoms, or a substituted or unsubstituted trialkylsilyl group.

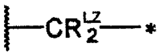 (L-1)

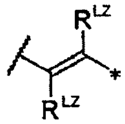 (L-2)

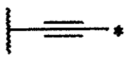 (L-3)

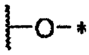 (L-4)

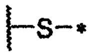 (L-5)

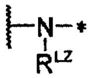 (L-6)

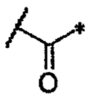 (L-7)

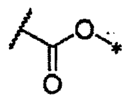 (L-8)

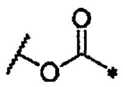 (L-9)

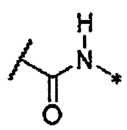 (L-10)

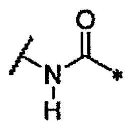 (L-11)

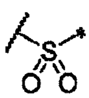 (L-12)

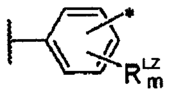 (L-13)

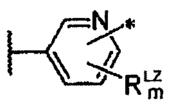 (L-14)

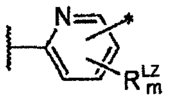 (L-15)

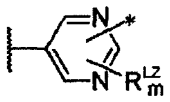 (L-16)

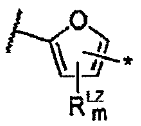 (L-17)

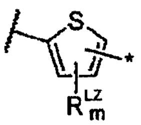 (L-18)

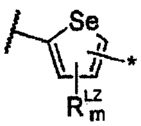 (L-19)

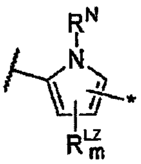 (L-20)

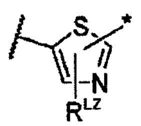 (L-21)

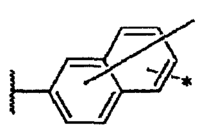 (L-22) (L-23)

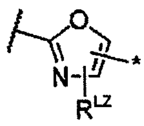 (L-23)

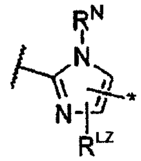 (L-24)

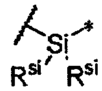 (L-25)

In Formulae (L-1) to (L-25), each wavy line represents a binding position with respect to a ring forming each skeleton represented by any of Formulae (C) to (T). Moreover, in the present specification, in a case where L represents a divalent linking group in which two or more divalent linking groups represented by any of Formulae (L-1) to (L25) are bonded to each other, each wavy line may represent a binding position with a ring forming each skeleton represented by any of Formulae (C) to (T) or a binding position with respect to any of the divalent linking groups represented by Formulae (L-1) to (L25).

The symbol "*" represents a binding position with respect to $R^W$ or a binding position with respect to a wavy line represented by any of Formula (L-1) to (L-25).

m in Formula (L-13) represents 4, m's in Formulae (L-14) and (L-15) represent 3, m's in Formulae (L-16) to (L-20) represent 2, and m in Formula (L-22) represents 6.

$R^{LZ}$'s in Formulae (L-1), (L-2), (L-6), (L-13) to (L-19), and (L-21) to (L-24) each independently represent a hydrogen atom or a substituent, and $R^{LZ}$'s in Formulae (L-1) and (L-2) may be respectively bonded to $R^W$ adjacent to L and form a condensed ring.

$R^N$'s represent a hydrogen atom or a substituent and $R^{si}$'s each independently represent a hydrogen atom, an alkyl group, an alkenyl group, or an alkynyl group.

It is more preferable that the divalent linking groups represented by Formulae (L-17) to (L21), (L-23), and (L-24) are divalent linking groups represented by the following Formulae (L-17A) to (L-21A), (L-23A), and (L-24A).

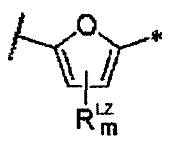
(L-17A)

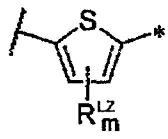
(L-18A)

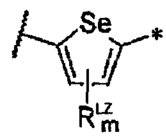
(L-19A)

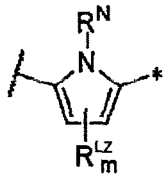
(L-20A)

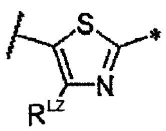
(L-21A)

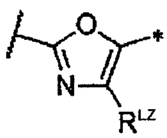
(L-23A)

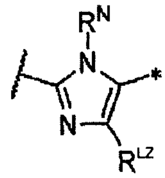
(L-24A)

Here, in a case where a substituted or unsubstituted alkyl group, a cyano group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group is present at the terminal of a substituent, this substituent can be interpreted as $-R^W$ alone in Formula (W) or as $-L-R^W$ in Formula (W).

In the present invention, in a case where a substituted or unsubstituted alkyl group having N carbon atoms in the main chain is present at the terminal of a substituent, this substituent is determined to be interpreted not as $-R^W$ alone but as $-L-R^W$ in Formula (W), including as many linking groups as possible from the terminal of the substituent. Specifically, this substituent is interpreted as a substituent in which "one (L-1) corresponding to L in Formula (W)" is bonded to "a substituted or unsubstituted alkyl group having N-1 carbon atoms in the main chain corresponding to $R^W$ in Formula (W)." For example, in a case where an n-octyl group which is an alkyl group having 8 carbon atoms is present at the terminal of a substituent, this substituent is interpreted as a substituent in which one (L-1) having two $R^{LZ}$'s representing a hydrogen atom is bonded to an n-heptyl group having 7 carbon atoms. Further, in a case where a substituent represented by Formula (W) is an alkoxy group having 8 carbon atoms, this substituent is interpreted as a substituent in which one linking group represented by -O- of Formula (L-4), one linking group represented by (L-1) in which two $R^{LZ}$'s represent a hydrogen atom, and an n-heptyl group having 7 carbon atoms are bonded to each other. Meanwhile, in the present invention, in a case where an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group is present at the terminal of a substituent, this substituent is interpreted as $R^W$ alone in Formula (W), including linking groups as many as possible from the terminal of the substituent. For example, in a case where a $-(OCH_2CH_2)-(OCH_2CH_2)-(OCH_2CH_2)-OCH_3$ group is present at the terminal of a substituent, this substituent is interpreted as an oligooxyethylene group alone in which the repeating number v of oxyethylene units is 3.

In a case where a linking group to which a divalent linking group in which L is represented by any of Formulae (L-1) to (L-25) is formed, the number of bonds of the divalent linking group represented by any of Formulae (L-1) to (L-25) is preferably in a range of 2 to 4 and more preferably 2 or 3.

Examples of the substituent $R^{LZ}$ in Formulae (L-1), (L-2), (L-6), and (L-13) to (L-24) include those exemplified as the substituents which may be employed by the substituents $R^C$ to $R^T$ of Formulae (C) to (T). Among these, it is preferable that the substituent RLZ in Formula (L-6) represents an alkyl group. In the case where $R^{LZ}$ in Formula (L-6) represents an alkyl group, the number of carbon atoms of the alkyl group is preferably in a range of 1 to 9, more preferably in a range of 4 to 9 from the viewpoints of chemical stability and carrier transportability, and still more preferably in a range of 5 to 9. In the case where $R^{LZ}$ in (L-6) is an alkyl group, it is preferable that the alkyl group is a linear alkyl group

from the viewpoint of improving the carrier transportability.

Examples of $R^N$ include those exemplified as the substituents which may be employed by the substituents $R^C$ to $R^T$. Among these, it is preferable that $R^N$ represents a hydrogen atom or a methyl group.

It is preferable that $R^{si}$ represents an alkyl group. The alkyl group which may be employed by $R^{si}$ is not particularly limited, but the preferable range of the alkyl group which may be employed by $R^{si}$ is the same as the preferable range of an alkyl group which may be employed by a silyl group in a case where $R^W$ represents a silyl group. The alkenyl group which may be employed as $R^{si}$ is not particularly limited, but a substituted or unsubstituted alkenyl group is preferable and a branched alkenyl group is more preferable as the alkenyl group. The number of carbon atoms thereof is preferably 2 or 3. The alkynyl group which may be employed as $R^{si}$ is not particularly limited, but a substituted or unsubstituted alkynyl group is preferable and a branched alkynyl group is more preferable as the alkynyl group. The number of carbon atoms thereof is preferably 2 or 3.

It is preferable that L represents a divalent linking group represented by any of Formulae (L-1) to (L-5), (L-13), (L-17), and (L-18) or a divalent linking group in which two or more divalent linking groups represented by any of Formulae (L-1) to (L-5), (L-13), (L-17), and (L-18) are bonded to each other, more preferable that L represents a divalent linking group represented by any of Formulae (L-1), (L-3), (L-13), and (L-18) or a divalent linking group in which two or more divalent linking groups represented by any of Formulae (L-1), (L-3), (L-13), and (L-18) are bonded to each other, and particularly preferable that L represents a divalent linking group represented by any of (L-1), (L-3), (L-13), and (L-18) or a divalent linking group in which a divalent linking group represented by any one of Formulae (L-3), (L-13), and (L-18) is bonded to a divalent linking group represented by Formula (L-1). In the divalent linking group in which a divalent linking group represented by any one of Formulae (L-3), (L-13), and (L-18) is bonded to a divalent linking group represented by Formula (L-1), it is preferable that the divalent linking group represented by Formula (L-1) is bonded to the $R^W$ side.

From the viewpoints of chemical stability and carrier transportability, it is particularly preferable that L represents a divalent linking group which has a divalent linking group represented by Formula (L-1), more particularly preferable that L represents a divalent linking group represented by Formula (L-1), still more particularly preferable that L represents a divalent linking group represented by Formula (L-18) or (L-1), the divalent linking group is bonded to $R^W$ through (L-1), and $R^W$ represents a substituted or unsubstituted alkyl group, and even still more particularly preferable that L represents a divalent linking group represented by Formula (L-18A) or (L-1), the divalent linking group is bonded to $R^W$ through (L-1), and $R^W$ represents a substituted or unsubstituted alkyl group.

In Formula (W), it is preferable that $R^W$ represents a substituted or unsubstituted alkyl group. In Formula (W), in a case where L adjacent to $R^W$ represents a divalent linking group represented by Formula (L-1), it is preferable that $R^W$ represents a substituted or unsubstituted alkyl group, an oxyethylene group, an oligooxyethylene group in which the repeating number of oxyethylene units is 2 or greater, a siloxane group, or an oligosiloxane group having 2 or more silicon atoms and more preferable that $R^W$ represents a substituted or unsubstituted alkyl group.

In Formula (W), in a case where L adjacent to $R^W$ represents a divalent linking group represented by any of Formulae (L-2) and (L-4) to (L-25), it is more preferable that $R^W$ represents a substituted or unsubstituted alkyl group.

In Formula (W), in a case where L adjacent to $R^W$ represents a divalent linking group represented by Formula (L-3), it is preferable that $R^W$ represents a substituted or unsubstituted alkyl group or a substituted or unsubstituted silyl group.

In a case where $R^W$ represents a substituted or unsubstituted alkyl group, the number of carbon atoms is preferably in a range of 4 to 17, more preferably in a range of 6 to 14 from the viewpoints of chemical stability and carrier transportability, and still more preferably in a range of 6 to 12. From the viewpoints of improving linearity of a molecule and carrier transportability, it is preferable that $R^W$ represents a long-chain alkyl group, particularly a long-chain linear alkyl group, within the above-described range.

In a case where $R^W$ represents an alkyl group, the alkyl group may be linear, branched, or cyclic, but it is preferable that the alkyl group is linear from the viewpoints of improving the linearity of a molecule and the carrier transportability.

As a combination of $R^W$ and L of Formula (W), from the viewpoint of improving the carrier mobility, it is preferable that L in Formulae (C) to (T) represents a divalent linking group represented by Formula (L-1) and $R^W$ represents a linear alkyl group having 4 to 17 carbon atoms or L represents a divalent linking group in which a divalent linking group represented by any one of Formulae (L-3), (L-13), or (L-18) is bonded to a divalent linking group represented by Formula (L-1) and $R^W$ represents a linear alkyl group.

In the case where L represents a divalent linking group represented by Formula (L-1) and $R^W$ represents a linear alkyl group having 4 to 17 carbon atoms, it is more preferable that $R^W$ represents a linear alkyl group having 6 to 14 carbon atoms from the viewpoint of improving the carrier mobility and particularly preferable that $R^W$ represents a linear alkyl group having 6 to 12 carbon atoms.

In the case where L represents a divalent linking group in which a divalent linking group represented by any one of Formulae (L-3), (L-13), and (L-18) is bonded to a divalent linking group represented by Formula (L-1) and $R^W$ represents a linear alkyl group, it is more preferable that $R^W$ represents a linear alkyl group having 4 to 17 carbon atoms,

more preferable that $R^W$ represents a linear alkyl group having 6 to 14 carbon atoms from the viewpoints of the chemical stability and carrier mobility, and particularly preferable that $R^W$ represents a linear alkyl group having 6 to 12 carbon atoms from the viewpoint of improving the carrier mobility.

Meanwhile, from the viewpoint of improving solubility in an organic solvent, it is preferable that $R^W$ represents a branched alkyl group.

In a case where $R^W$ represents an alkyl group having a substituent, a halogen atom may be exemplified as the substituent and a fluorine atom is preferable. Moreover, in a case where $R^W$ represents an alkyl group having a fluorine atom, all hydrogen atom of the alkyl group may be substituted with fluorine atoms to form a perfluoroalkyl group. In this case, it is preferable that $R^W$ represents an unsubstituted alkyl group.

In a case where $R^W$ represents an ethyleneoxy group or an oligoethyleneoxy group, in the present specification, the "oligooxyethylene group" represented by $R^W$ indicates a group represented by $-(OCH_2CH_2)_vOY$ (the repeating number v of oxyethylene units is an integer of 2 or greater and Y at the terminal represents a hydrogen atom or a substituent). Further, in a case where Y at the terminal of the oligooxyethylene group represents a hydrogen atom, this becomes a hydroxy group. The repeating number v of the oxyethylene units is preferably in a range of 2 to 4 and more preferably 2 or 3. It is preferable that the hydroxy group at the terminal of the oligooxyethylene group is sealed, that is, Y represents a substituent. In this case, it is preferable that the hydroxy group is sealed by an alkyl group having 1 to 3 carbon atoms, that is, Y represents an alkyl group having 1 to 3 carbon atoms, more preferable that Y represents a methyl group or an ethyl group, and particularly preferable that Y represents a methyl group.

In a case where $R^W$ represents a siloxane group or an oligosiloxane group, the repeating number of siloxane units is preferably 2 to 4 and more preferably 2 or 3. Further, it is preferable that a hydrogen atom or an alkyl group is bonded to a Si atom. In a case where an alkyl group is bonded to a Si atom, the number of carbon atoms of the alkyl group is preferably in a range of 1 to 3, and it is preferable that a methyl group or an ethyl group is bonded to the Si atom. The same alkyl groups may be bonded to a Si atom or alkyl groups which are different from each other or hydrogen atoms may be bonded thereto. In addition, all siloxane units constituting an oligosiloxane group may be the same as or different from each other, but it is preferable that all siloxane units are the same as each other.

In a case where L adjacent to $R^W$ represents a divalent linking group represented by Formula (L-3), it is also preferable that $R^W$ represents a substituted or unsubstituted silyl group. In the case where $R^W$ represents a substituted or unsubstituted silyl group, it is preferable that $R^W$ represents a substituted silyl group. The substituted of the silyl group is not particularly limited, but a substituted or unsubstituted alkyl group is preferable and a branched alkyl group is more preferable as the substituent. In the case where $R^W$ represents a trialkylsilyl group, the number of carbon atoms of an alkyl group bonded to a Si atom is preferably in a range of 1 to 3, and it is preferable that a methyl group, an ethyl group, or an isopropyl group is bonded to a Si atom. Alkyl groups which are the same as or different from each other may be bonded to a Si atom. In a case where $R^W$ represents a trialkylsilyl group having other substituents in addition to an alkyl group, the substituents are not particularly limited.

In Formula (W), the total number of carbon atoms included in L and $R^W$ is preferably in a range of 5 to 18. When the total number of carbon atoms included in L and $R^W$ is greater than or equal to the lower limit of the above-described range, the carrier mobility is increased and the driving voltage is lowered. The total number of carbon atoms included in L and $R^W$ is less than or equal to the upper limit of the above-described range, the solubility in an organic solvent is increased.

The total number of carbon atoms included in L and $R^W$ is preferably in a range of 5 to 14, more preferably in a range of 6 to 14, particularly preferably in a range of 6 to 12, and more particularly preferably in a range of 8 to 12.

Among the substituents $R^C$ to $R^T$ in respective compounds represented by Formulae (C) to (T), the number of groups represented by Formula (W) is preferably in a range of 1 to 4 from the viewpoints of improving the carrier mobility and the solubility in an organic solvent, more preferably 1 or 2, and particularly preferably 2.

Among the substituents the $R^C$ to $R^T$, the positions of groups represented by Formula (W) are not particularly limited.

In the compound represented by Formula (C), a group in which any of $R^{C1}$, $R^{C2}$, $R^{C3}$, and $R^{C6}$ is represented by Formula (W) is preferable and a group in which both of $R^{C1}$ and $R^{C2}$ or both of $R^{C3}$ and $R^{C6}$ are represented by Formula (W) is more preferable.

In the compound represented by Formula (D), a group in which $R^{D6}$ is represented by Formula (W) is preferable and a group in which both of $R^{D5}$ and $R^{D6}$ are represented by Formula (W) is more preferable.

In the compound represented by Formula (E), a group in which $R^{E6}$ is represented by Formula (W) is preferable and a group in which both of $R^{E5}$ and $R^{E6}$ are represented by Formula (W) is more preferable. Further, in a case of a substituent other than the group in which both of $R^{E5}$ and $R^{E6}$ are represented by Formula (W), a group in which two $R^{E7}$'s are represented by Formula (W) is also preferable.

In the compound represented by Formula (F), a substituent in which at least one of $R^{F2}$, $R^{F3}$, $R^{F8}$, or $R^{F9}$ is represented by Formula (W) is preferable.

In the compound represented by Formula (G), a group in which $R^{G5}$ or $R^{G6}$ is represented by Formula (W) is

preferable from the viewpoints of improving the carrier mobility and the solubility in an organic solvent.

In the compound represented by Formula (H), a group in which $R^{H4}$ or $R^{H6}$ is represented by Formula (W) is preferable and a group in which $R^{H4}$ or $R^{H6}$ and $R^{H3}$ or $R^{H5}$ are represented by Formula (W) is more preferable.

In the compound represented by Formula (J), a group in which $R^{J8}$ is represented by Formula (W) is preferable and a group in which both of $R^{J8}$ and $R^{J4}$ are represented by Formula (W) is more preferable.

In the compound represented by Formula (K), a group in which $R^{K7}$ is represented by Formula (W) is preferable and a group in which both of $R^{K7}$ and $R^{K3}$ are represented by Formula (W) is more preferable.

In the compound represented by Formula (L), a group in which at least one of $R^{L2}$, $R^{L3}$, $R^{L6}$, or $R^{L7}$ is represented by Formula (W) is more preferable.

In the compound represented by Formula (M), a group in which $R^{M2}$ is represented by Formula (W) is preferable and a group in which both of $R^{M2}$ and $R^{M6}$ are represented by Formula (W) is more preferable.

In the compound represented by Formula (N), a group in which $R^{N3}$ is represented by Formula (W) is preferable and a group in which both of $R^{N3}$ and $R^{N9}$ are represented by Formula (W) is more preferable.

In the compound represented by Formula (P), a group in which $R^{P2}$ or $R^{P3}$ is represented by Formula (W) is preferable and a group in which both of $R^{P2}$ and $R^{P8}$ or both of $R^{P3}$ and $R^{P9}$ are represented by Formula (W) is more preferable.

In the compound represented by Formula (Q), a group in which $R^{Q3}$ is represented by Formula (W) is preferable and a group in which both of $R^{Q3}$ and $R^{Q9}$ are represented by

Formula (W) is more preferable.

In the compound represented by Formula (R), a group in which $R^{R2}$ is represented by Formula (W) is preferable and a group in which both of $R^{R2}$ and $R^{R7}$ are represented by Formula (W) is more preferable.

In the compound represented by Formula (S), a group in which $R^{S2}$ is represented by Formula (W) is preferable and a group in which both of $R^{S2}$ and $R^{S5}$ are represented by Formula (W) is more preferable.

In the compound represented by Formula (T), a group in which $R^{T2}$ is represented by Formula (W) is preferable and a group in which both of $R^{T2}$ and $R^{T5}$ are represented by Formula (W) is more preferable.

Among the substituents $R^C$ to $R^T$, the number of substituents other than the groups represented by Formula (W) is preferably in a range of 0 to 4 and more preferably in a range of 0 to 2.

Hereinafter, specific examples of respective compounds represented by Formulae (C) to (T) will be described, but the compounds which can be used in the present invention should not be limitatively interpreted by these specific examples.

Specific examples of compounds C represented by Formula (C) are described.

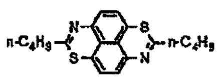

Compound C1

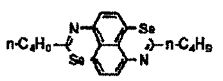

Compound C2

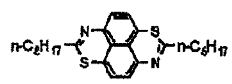

Compound C3

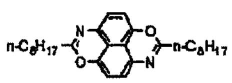

Compound C4

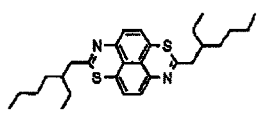

Compound C5

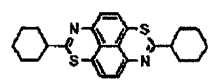

Compound C6

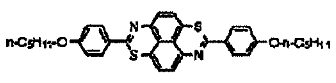

Compound C7

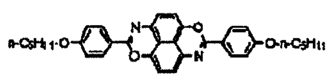

Compound C8

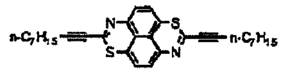

Compound C9

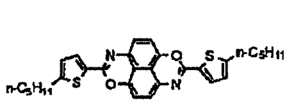

Compound C10

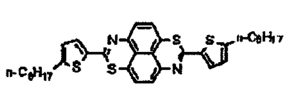

Compound C11

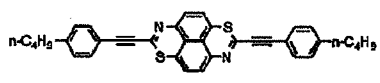

Compound C12

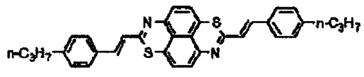

Compound C13

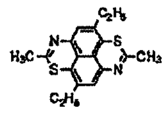

Compound C14

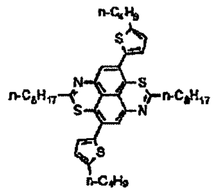

Compound C15

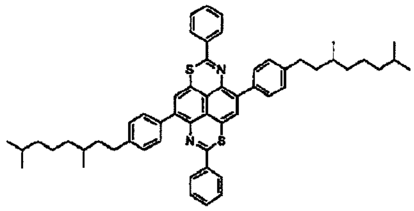

Compound C16

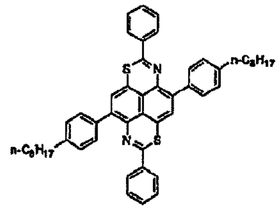

Compound C17

The molecular weight of a compound represented by Formula (C) is preferably 3000 or less, more preferably 2000 or less, still more preferably 1000 or less, and particularly preferably 850 or less. When the molecular weight is in the above-described range, the solubility in a solvent can be improved.

Meanwhile, from the viewpoint of stable film quality of a thin film, the molecular weight thereof is preferably 300 or greater, more preferably 350 or greater, and still more preferably 400 or greater.

Specific examples of compounds D represented by Formula (D) are described.

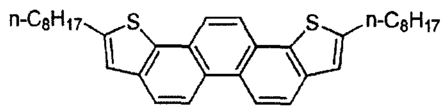

Compound D1

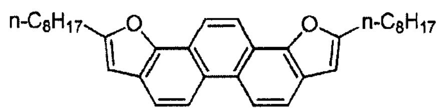

Compound D2

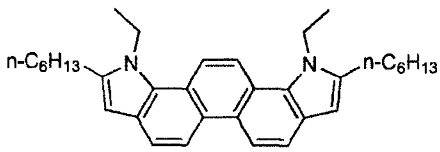

Compound D3

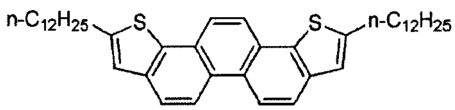

Compound D4

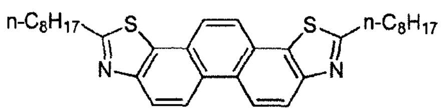

Compound D5

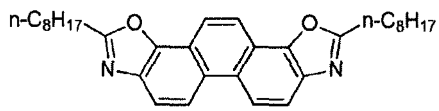

Compound D6

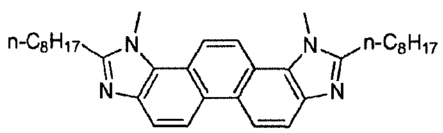

Compound D7

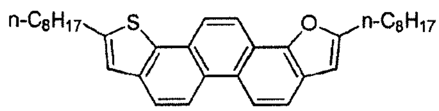

Compound D8

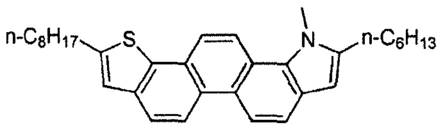

Compound D9

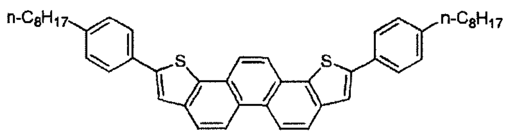

Compound D10

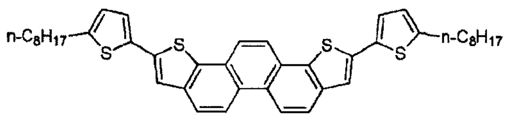

Compound D11

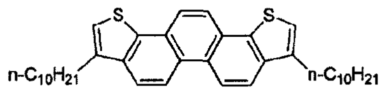

Compound D12

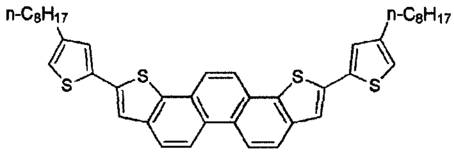

Compound D13

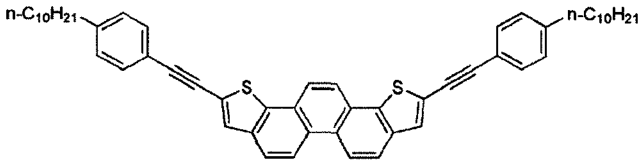

Compound D14

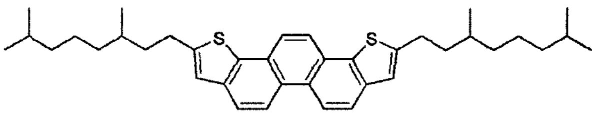

Compound D15

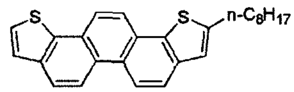

Compound D16

From the viewpoint of improving the solubility in a solvent, it is preferable that the upper limit of the molecular weight of a compound represented by Formula (D) is the same as that of the compound represented by Formula (C). Meanwhile, from the viewpoint of stable film quality of a thin film, the molecular weight thereof is preferably 400 or greater, more preferably 450 or greater, and still more preferably 500 or greater.

Specific examples of a compound E represented by Formula (E), a compound F represented by Formula (F), a compound G represented by Formula (G), and a compound H represented by Formula (H) are respectively described in order.

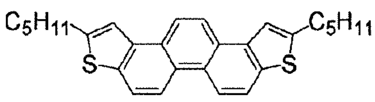

Compound E1

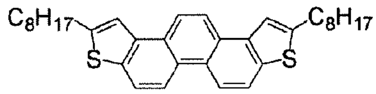

Compound E2

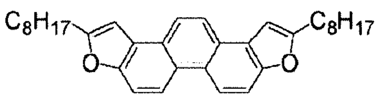

Compound E3

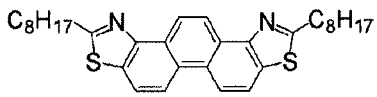

Compound E4

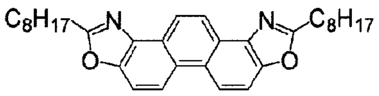

Compound E5

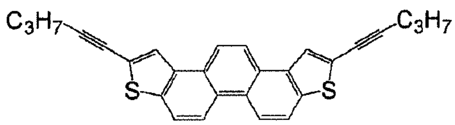

Compound E6

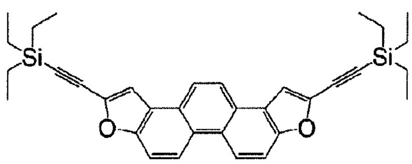

Compound E7

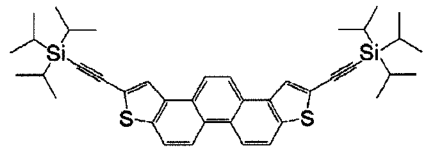

Compound E8

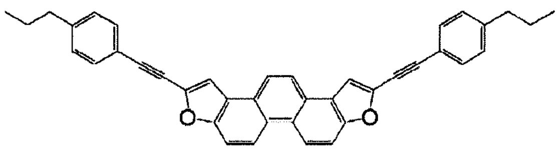

Compound E9

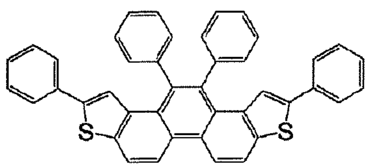

Compound E10

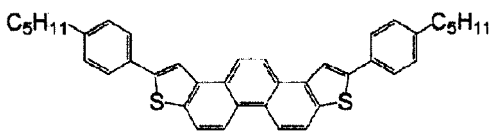

Compound E11

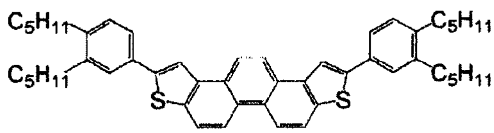

Compound E12

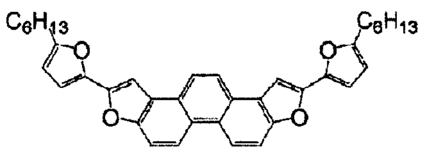

Compound E13

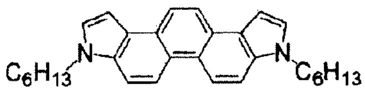

Compound E14

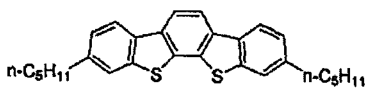

Compound F1

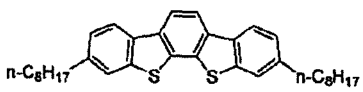

Compound F2

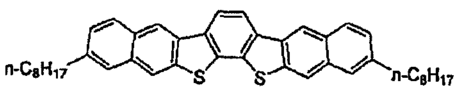

Compound F3

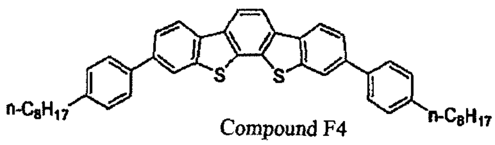

Compound F4

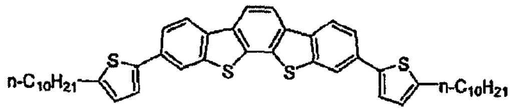

Compound F5

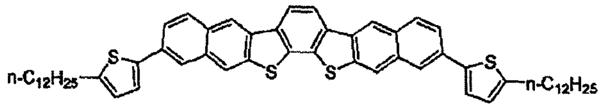

Compound F6

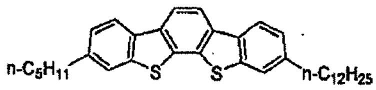

Compound F7

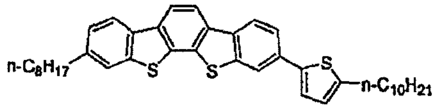

Compound F8

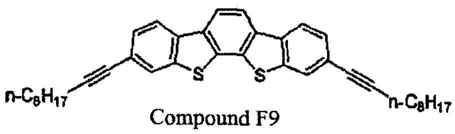

Compound F9

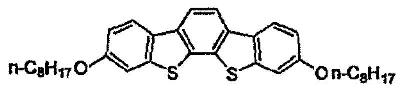

Compound F10

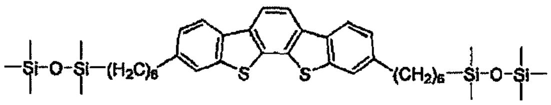

Compound F11

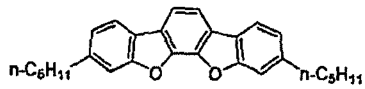

Compound F12

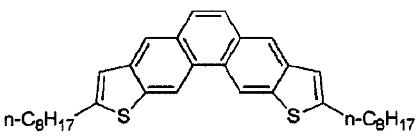

Compound G1

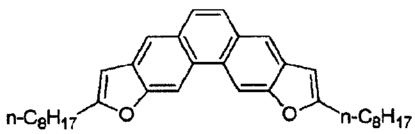

Compound G2

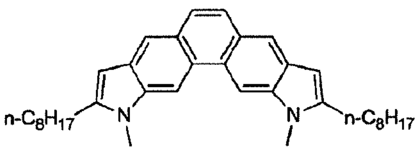

Compound G3

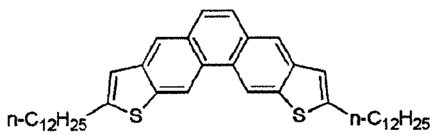

Compound G4

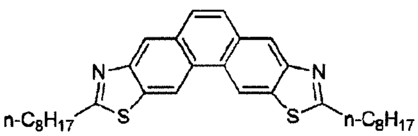

Compound G5

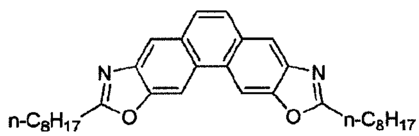

Compound G6

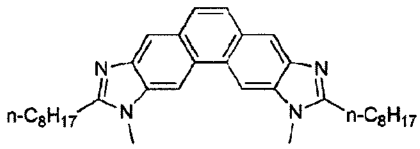

Compound G7

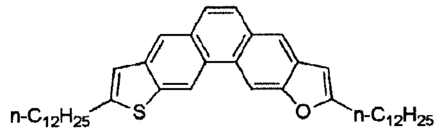

Compound G8

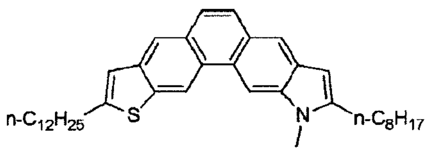

Compound G9

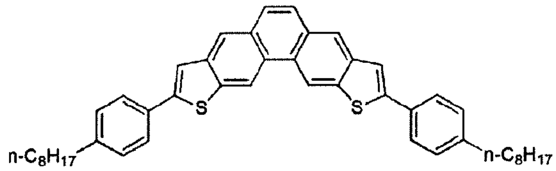

Compound G10

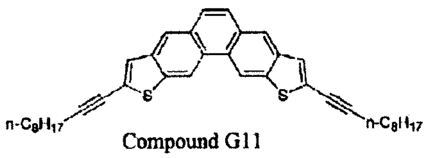

Compound G11

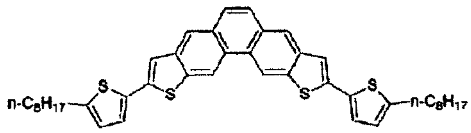

Compound G12

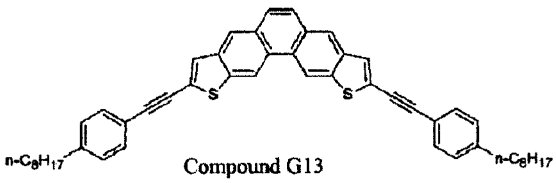

Compound G13

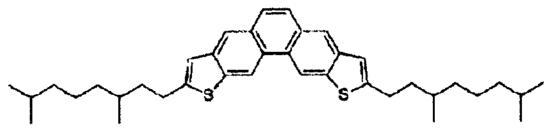

Compound G14

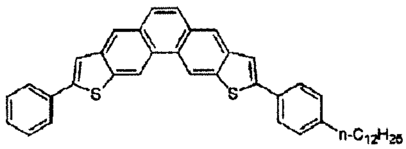

Compound G15

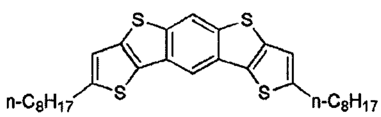

Compound H1

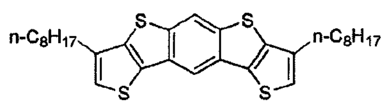

Compound H2

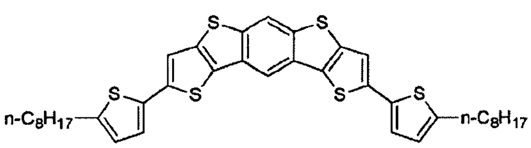

Compound H3

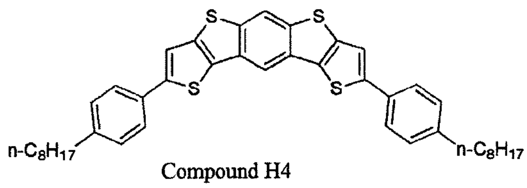

Compound H4

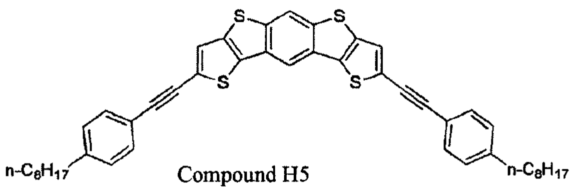

Compound H5

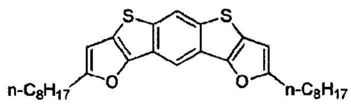

Compound H6

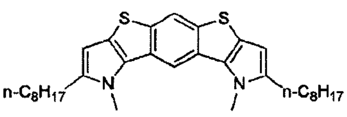

Compound H7

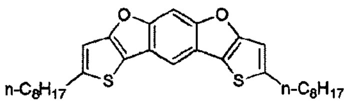

Compound H8

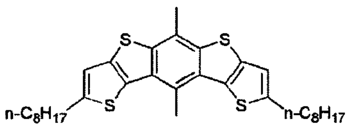

Compound H9

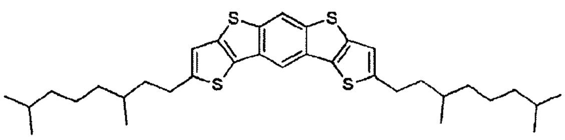

Compound H10

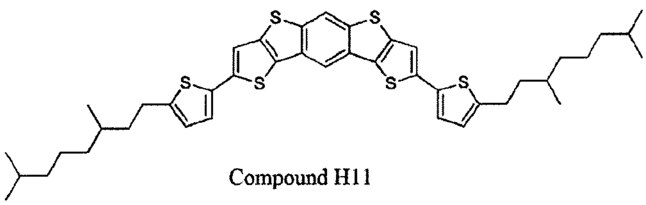

Compound H11

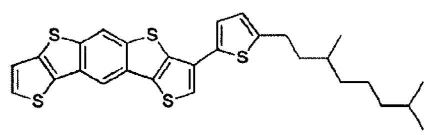

Compound H12

From the viewpoint of improving the solubility in a solvent, it is preferable that the upper limits of the molecular weights of the compounds E, F, G, and H are respectively the same as that of the compound C represented by Formula (C). Meanwhile, from the viewpoint of stable film quality of a thin film, the lower limits of the molecular weights thereof are respectively the same as that of the compound represented by Formula (D).

Specific examples of a compound J represented by Formula (J) and a compound K represented by Formula (K) are described.

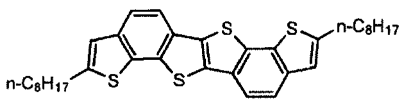

Compound J1

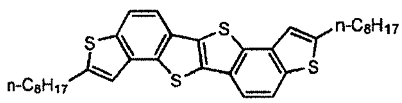

Compound K1

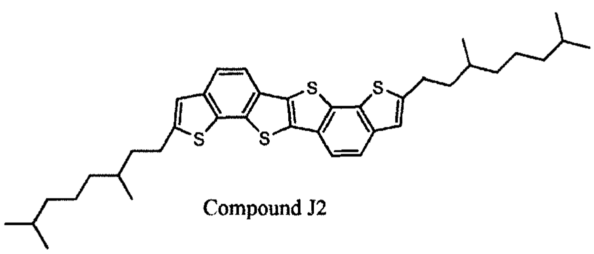

Compound J2

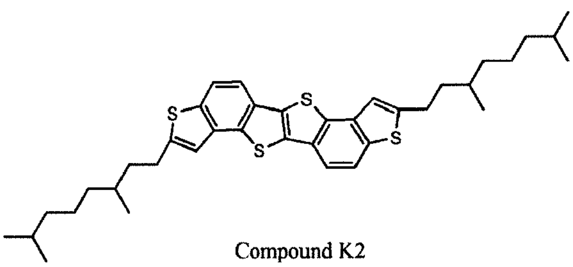

Compound K2

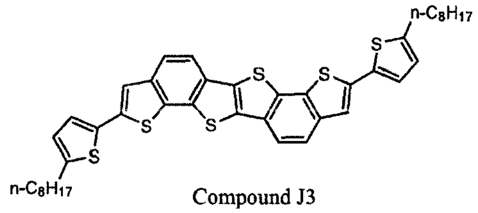

Compound J3

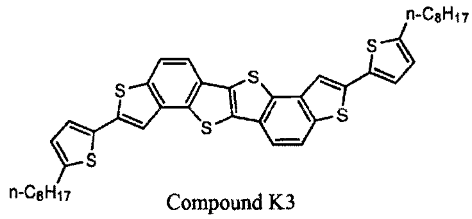

Compound K3

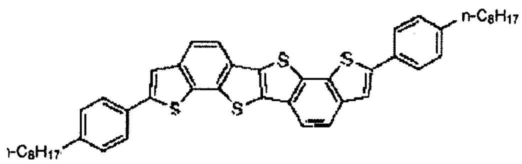

Compound J4

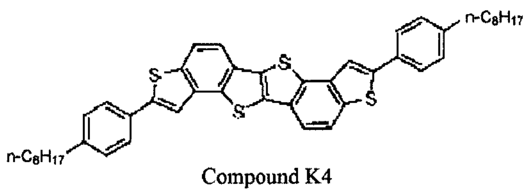

Compound K4

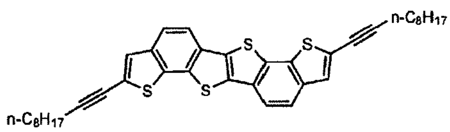

Compound J5

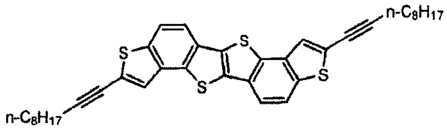

Compound K5

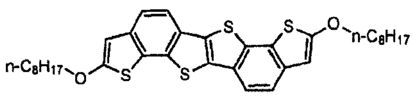

Compound J6

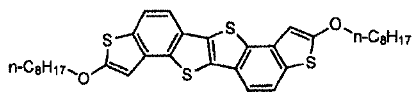

Compound K6

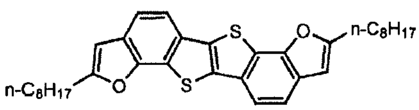

Compound J7

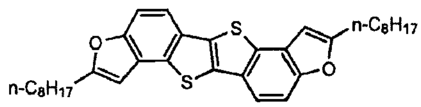

Compound K7

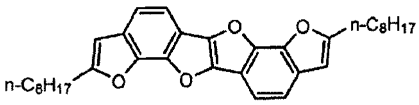

Compound J8

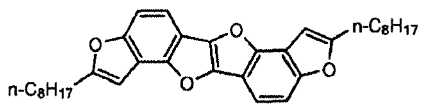

Compound K8

From the viewpoint of improving the solubility in a solvent, it is preferable that the upper limits of the molecular weights of the compounds J and K are respectively the same as that of the compound C represented by Formula (C). Meanwhile, from the viewpoint of stable film quality of a thin film, the lower limits of the molecular weights thereof are respectively the same as that of the compound represented by Formula (D).

Specific examples of a compound L represented by Formula (L), a compound M represented by Formula (M), a compound N represented by Formula (N), a compound P represented by Formula (P), and a compound Q represented by Formula (Q) are respectively described in order.

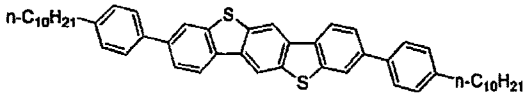

Compound L1

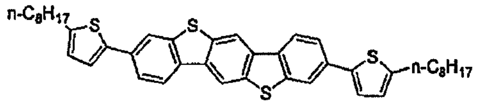

Compound L2

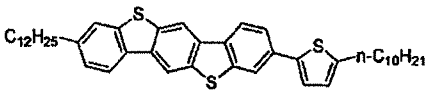

Compound L3

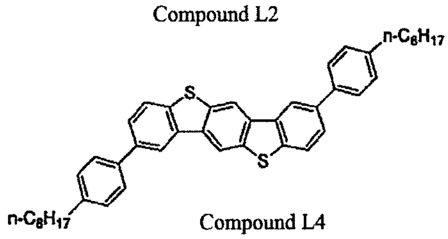

Compound L4

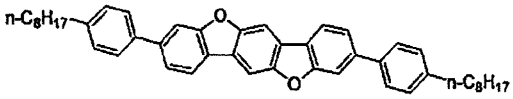

Compound L5

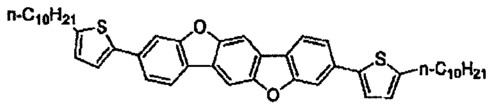

Compound L6

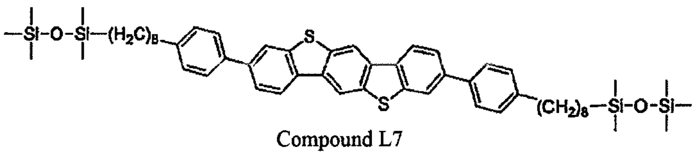

Compound L7

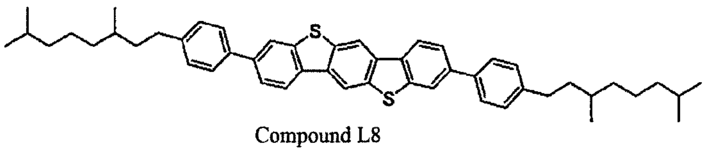

Compound L8

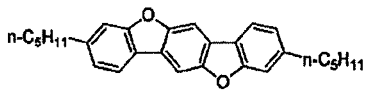

Compound L9

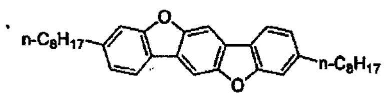

Compound L10

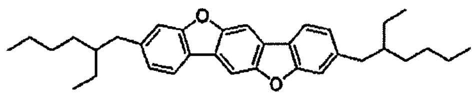

Compound L11

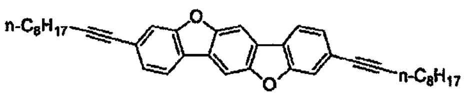

Compound L12

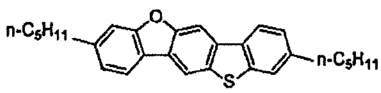

Compound L13

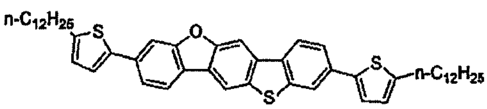

Compound L14

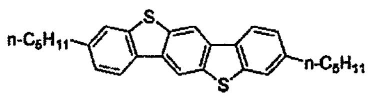

Compound L15

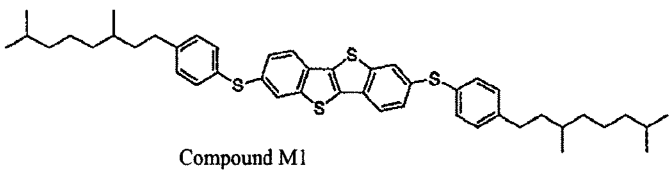

Compound M1

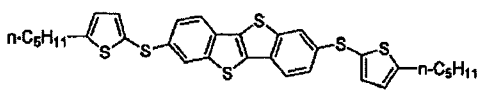

Compound M2

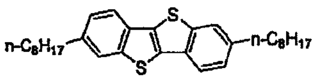

Compound M3
(C8BTBT)

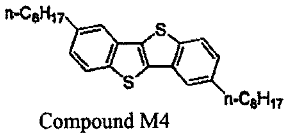

Compound M4

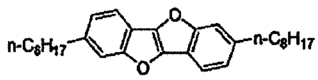

Compound M5

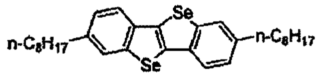

Compound M6

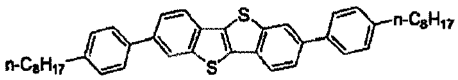

Compound M7

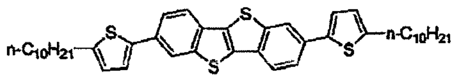

Compound M8

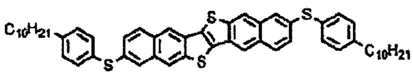

Compound N1

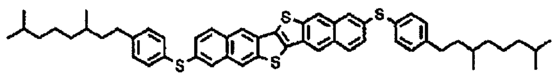

Compound N2

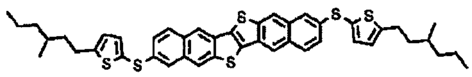

Compound N3

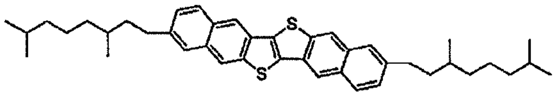

Compound N4

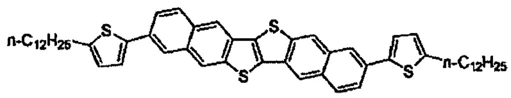

Compound N5

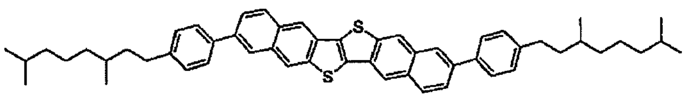

Compound N6

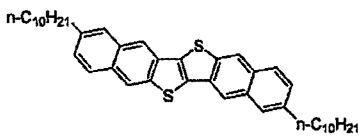

Compound N7

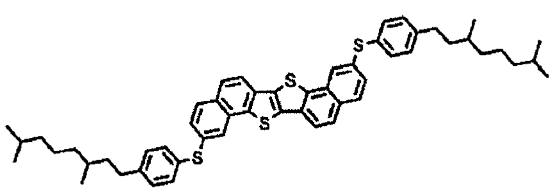

Compound P1

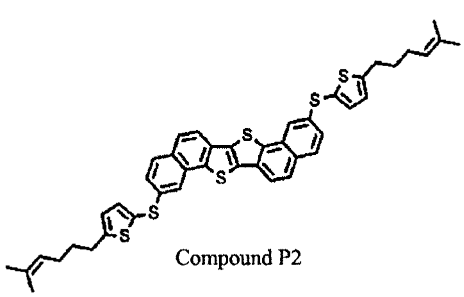

Compound P2

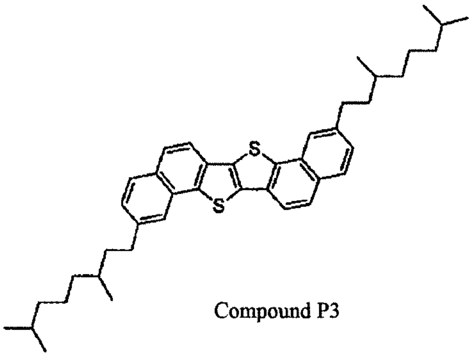

Compound P3

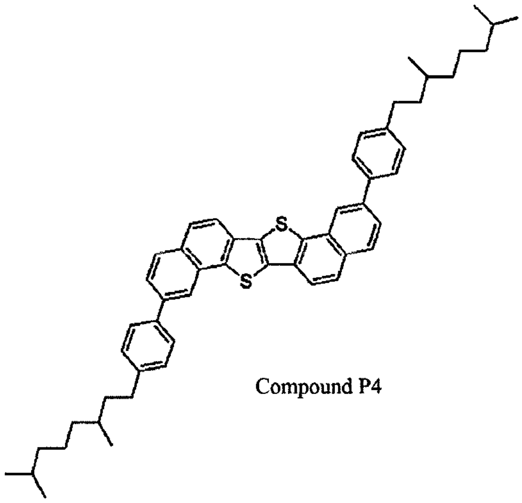

Compound P4

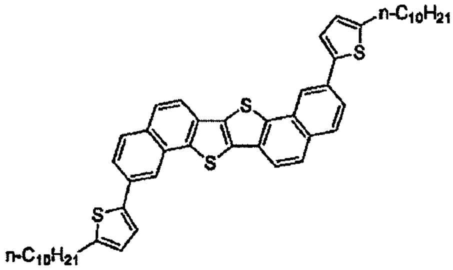

Compound P5

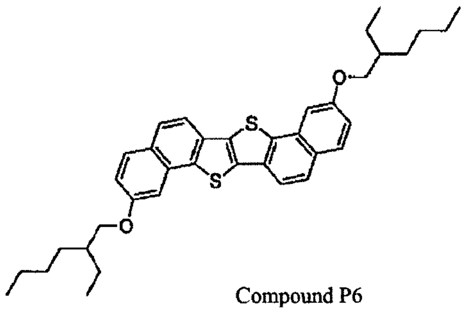

Compound P6

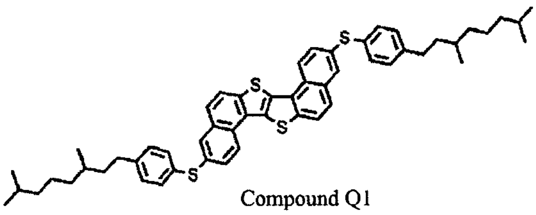

Compound Q1

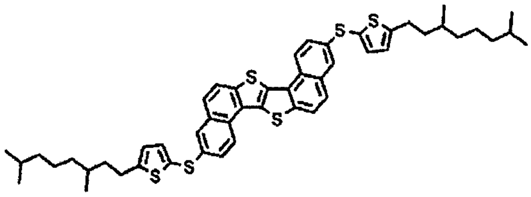

Compound Q2

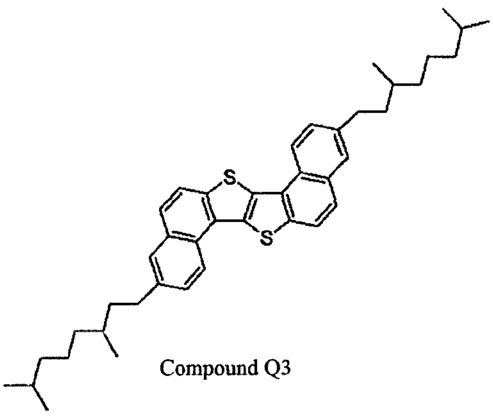

Compound Q3

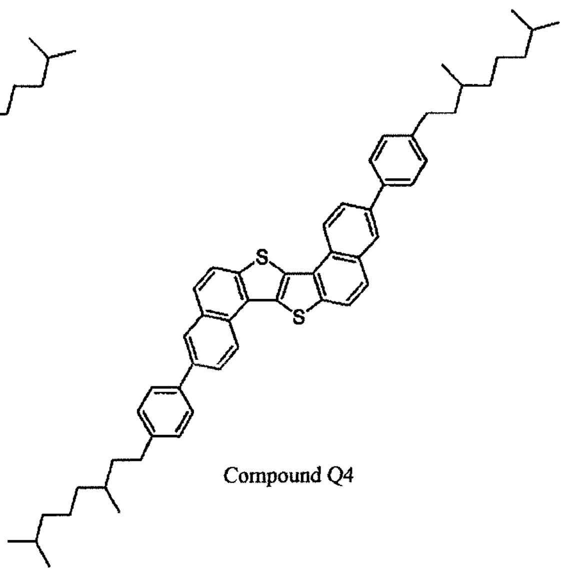

Compound Q4

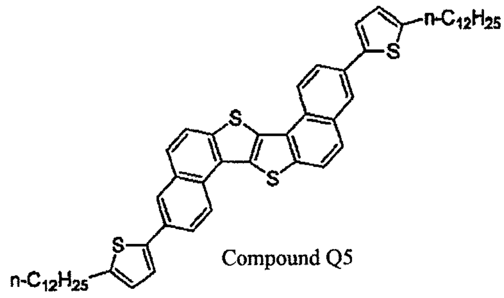

Compound Q5

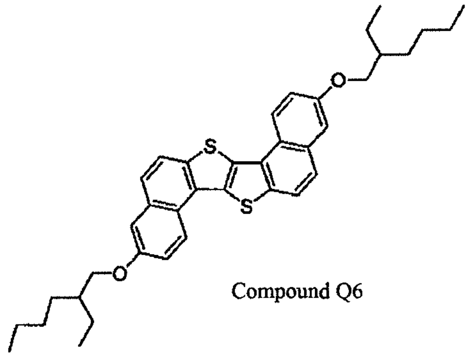

Compound Q6

From the viewpoint of improving the solubility in a solvent, it is preferable that the upper limits of the molecular weights of the compounds L, M, N, P, and Q are respectively the same as that of the compound C represented by Formula (C). Meanwhile, from the viewpoint of stable film quality of a thin film, the lower limits of the molecular weights thereof are respectively the same as that of the compound represented by Formula (D).

Specific examples of a compound R represented by Formula (R), a compound S represented by Formula (S), and a compound T represented by Formula (T) are respectively described in order.

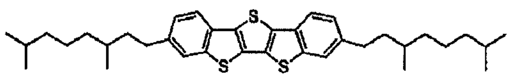

Compound R1

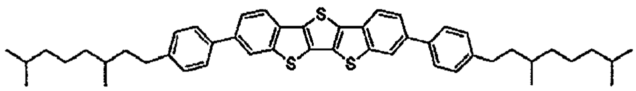

Compound R2

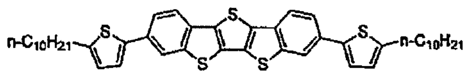

Compound R3

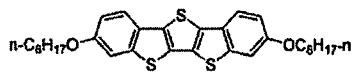

Compound R4

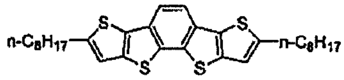

Compound S1

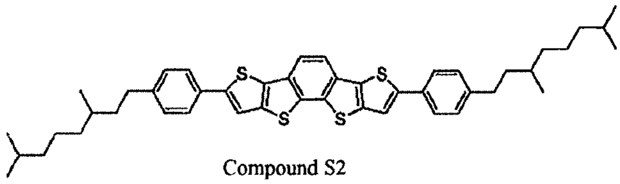

Compound S2

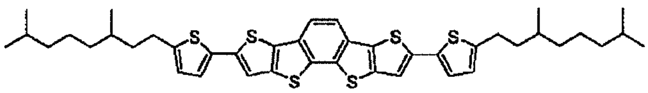

Compound S3

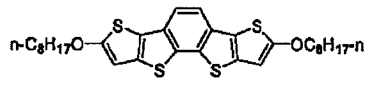

Compound S4

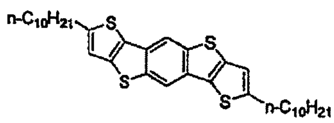

Compound T1

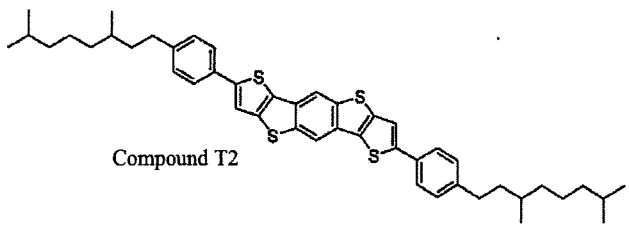

Compound T2

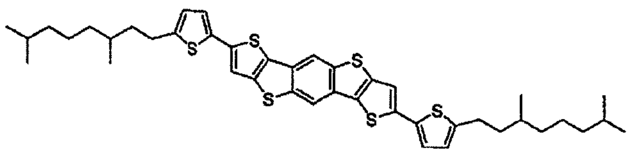

Compound T3

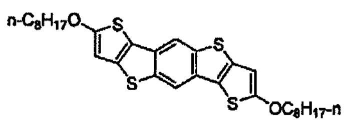

Compound T4

From the viewpoint of improving the solubility in a solvent, it is preferable that the upper limits of the molecular weights of the compounds R, S, and T are respectively the same as that of the compound C represented by Formula (C). Meanwhile, from the viewpoint of stable film quality of a thin film, the lower limits of the molecular weights thereof are respectively the same as that of the compound represented by Formula (D).

Examples of an organic polymer and a derivative thereof include polypyrrole and a derivative thereof, polydiketopyrrole and a derivative thereof, polythiophene and a derivative thereof, isothianaphthene such as polyisothianaphthene, thienylene vinylene such as polythienylene vinylene, poly(p-phenylenevinylene) such as poly(p-phenylenevinylene), polyaniline and a derivative thereof, polymers such as polyacetylene, polydiacetylene, polyazulene, polypyrene, polycarbazole, polyselenophene, polyfuran, poly(p-phenylene), polyindole, polypyridazine, polytellurophene, polynaphthalene, polyvinylcarbazole, polyphenylene sulfide, and polyvinylene sulfide, and a polymer of a condensed polycyclic aromatic compound.

The polythiophene and a derivative thereof are not particularly limited, and examples thereof include poly-3-hexylthiophene (P3HT) in which a hexyl group is introduced into polythiophene, polyethylene dioxythiophene, and poly(3,4-ethylenedioxythiophene)/polystyrenesulfonic acid (PEDOT/PSS).

Further, oligomers (such as oligothiophene) having repeating units which are the same as those of these polymers may also be exemplified.

Moreover, examples of the organic polymer include polymer compounds in which compounds represented by the following Formulae (C) to (T) have a repeating structure.

Examples of such polymers compound include $\pi$-conjugated polymers in which the compounds represented by Formulae (C) to (T) have a repeating structure through at least one or more arylene groups and heteroarylene groups (such as thiophene or bithiophene) and pendant type polymers in which the compounds represented by Formulae (C) to (T) are bonded to the polymer main chains through the side chains. Preferred examples of the polymer main chain include polyacrylate, polyvinyl, and polysiloxane and preferred examples of the side chain include an alkylene group and a polyethylene oxide group. In a case of the pendant type polymer, the polymer main chain may be formed by at least one of the substituents $R^C$, ..., or $R^T$ having a group derived from a polymerizable group to be polymerized.

The weight average molecular weight of these organic polymers is preferably 30000 or greater, more preferably 50000 or greater, and still more preferably 100000 or greater. When the weight average molecular weight is the above-described lower limit or greater, intermolecular interaction can be increased so that high mobility is obtained.

[Source electrode and drain electrode]

In the OTFT of the present invention, a source electrode is an electrode into which a current from the outside flows through wiring. Further, a drain electrode is an electrode that sends the current to the outside through the wiring and is typically provided in contact with the above-described semiconductor layer.

As materials of the source electrode and the drain electrode, conductive materials used for organic thin-film transistors of the related art can be used, and examples thereof include the conductive materials described in the section of the gate electrode above.

The source electrode and the drain electrode can be respectively formed according to the same method as the method of forming the above-described gate electrode.

The above-described photolithography method, a lift-off method or an etching method can be employed.

Particularly, since the gate insulating layer has excellent resistance to an etching solution or a stripping solution, the source electrode and the drain electrode can be suitably formed even when an etching method is employed. The etching method is a method of removing unnecessary portions by etching after a film is formed using a conductive material. When patterning is performed according to the etching method, it is possible to prevent peeling of a conductive material remaining on a base at the time of removing a resist and to prevent re-attachment of resist residues or the removed conductive material to the base. Accordingly, the shape of an electrode edge portion is excellent. From this viewpoint, the etching method is preferred than the lift-off method.

The lift-off method is a method of coating a portion of a base with a resist, forming a film thereon with a conductive material, and eluting or peeling the resist and the like using a solvent so that the conductive material on the resist is entirely removed, and then forming a film of the conductive material only on the portion which is not coated with the resist.

The thicknesses of the source material and the drain material are optional, but are respectively preferably 1 nm or greater and particularly preferably 10 nm or greater. Further, the thickness thereof is preferably 500 nm or less and particularly preferably 300 nm or less.

The space (channel length) between the source electrode and the drain electrode is optional, but is preferably 100 μm or less and particularly preferably 50 μm or less. Further, the channel width thereof is preferably 5000 μm or less and particularly preferably 1000 μm or less.

[Overcoat layer]

The OTFT of the present invention may have an overcoat layer. The overcoat layer is typically a layer formed on the surface of an OTFT as a protective layer. The overcoat layer may have a single-layer structure or a multi-layer structure.

The overcoat layer may be organic or inorganic.

The material forming an organic overcoat layer is not particularly limited, and examples thereof include organic polymers such as polystyrene, an acrylic resin, polyvinyl alcohol, polyolefin, polyimide, polyurethane, polyacetylene, and an epoxy resin, and derivatives obtained by introducing a crosslinkable group or a water-repellent group into these organic polymers. These organic polymers or derivatives thereof can be also used in combination with a crosslinking component, a fluorine compound, or a silicon compound.

The material forming an inorganic overcoat layer is not particularly limited, and examples thereof include metal oxides such as silicon oxide and aluminum oxide, and metal nitrides such as silicon nitride.

These materials may be used alone or in combination of optional two or more kinds thereof at an optional ratio.

A method of forming an overcoat layer is not limited and an overcoat layer can be formed according to known various methods.

For example, an organic overcoat layer can be formed using a method of coating an underlayer with a solution containing a material which becomes the overcoat layer, drying the layer, exposing the layer to light, and developing the layer to be patterned. Moreover, the patterning of the overcoat layer can be directly formed using a printing method or an ink-jet method. In addition, after the overcoat layer is patterned, the overcoat layer may be cross-linked by being exposed to light or heated.

Meanwhile, an inorganic overcoat layer can be formed using a dry method such as a sputtering method or a vapor deposition method or a wet method such as a sol-gel method.

[Other layers]

The OTFT of the present invention may be provided with other layers or members.

As other layers or members, a bank may be exemplified. A bank is used for the purpose of holding a discharge liquid in a predetermined position when a semiconductor layer or an overcoat layer is formed using an ink-jet method. For this reason, a bank typically has liquid repellency. Examples of forming a bank include a method of performing a liquid repellent treatment such as a fluorine plasma method after patterning is performed according to a photolithography method or the like and a method of curing a photosensitive composition or the like containing liquid repellent components such as a fluorine compound.

In a case of the organic thin-film transistor of the present invention, since a gate insulating layer is an organic layer, the latter method of curing a photosensitive composition containing liquid repellent components is preferable from the viewpoint that the gate insulating layer is not affected by the liquid repellent treatment. In addition, a technique of allowing a base to have a contrast of liquid repellency without using a bank so that the base plays the same role as that of a bank may be used.

[Use of OTFT]

It is preferable that the OTFT of the present invention is mounted on a display panel for use. Examples of the display panel include a liquid crystal panel, an organic EL panel, and an electron paper panel.

Examples

Hereinafter, the present invention will be described in detail based on examples, but the present invention is not limited to those examples.

[Preparation Example 1] Preparation of bottom-gate type OTFT -1

<First gate insulating layer>

A bottom-gate bottom-contact type OTFT illustrated in Fig. 1A was prepared. A gate electrode was obtained by forming an ITO film having a thickness of 70 nm on a glass substrate having a thickness of 1.1 mm which was used as a substrate 6. The gate electrode was coated with a polyimide-based alignment film solution (SE-130, polyimide precursor solution, manufactured by Nissan Chemical Industries, Ltd.) diluted to 2 wt% using N-methyl-2-pyrrolidone such that the gate electrode was covered, and then the gate electrode was dried at 100°C for 10 minutes. Thereafter, a polyimide film (thickness from the surface of the gate electrode on the first insulating layer side: 100 nm) was obtained by performing imidization at 230°C for 2 hours. The first gate insulating layer was formed by performing a rubbing treatment (alignment treatment) on the surface of this film using cotton cloth.

<Second gate insulating layer>

Coating solutions having a solid content concentration of 10 wt% were prepared by dissolving polymerizable liquid crystalline compounds (liquid crystalline monomers) listed in the following table and a polymerization initiator listed in the following table in methyl ethyl ketone. The content of the polymerization initiator in the coating solutions was set to 3 parts by mass with respect to 100 parts by mass of the liquid crystalline monomers. Further, surfactants (air interface alignment control agents) listed in the following table were added to some coating solutions such that the contents of the surfactants became 0.5 parts by mass with respect to 100 parts by mass of the liquid crystalline monomers in the coating solutions.

The surface of the first gate insulating layer subjected to a rubbing treatment was spin-coated with the obtained coating solutions (2000 rotations for 10 seconds). Subsequently, the alignment of the polymerizable liquid crystalline monomers was allowed to be aged by heating the surface thereof at 110°C. Next, the liquid crystalline monomers were polymerized by irradiating the surface with ultraviolet rays (integrated amount of irradiation: 500 $mJ/cm^2$, 10 seconds) at a temperature of 60°C, 130°C, or 140°C to immobilize the aligned state, thereby forming a second gate insulating layer (thickness: 220 nm). Moreover, in the case of the coating solutions to which the surfactant was added, the second gate insulating layer was immersed in a methyl ethyl ketone solution after the polymerization reaction and washed with ultrasonic waves, and then the surfactant was removed from the second gate insulating layer.

In addition, the "state of a liquid crystal phase before the polymerization reaction" in the following table when the second gate insulating layer was formed was evaluated by observing the optical texture using a polarizing microscope. Further, the "aligned state of the surface of the second gate insulating layer on the organic semiconductor layer side" after the polymerization reaction (after polymerization and immobilization) was evaluated by measuring the retardation according to a Senarmont method.

[Table 1]

| Second gate insulating layer | Polymerizable liquid crystalline compound | Polymerization initiator | Surfactant | State of liquid crystal phase before polymerization reaction | Temperature of polymerization reaction (°C) | Aligned state of surface on organic semiconductor layer side after polymerization reaction |
|---|---|---|---|---|---|---|
| X1 | Liquid crystalline monomer a | IRGACURE 907 | Surfactant a | Nematic | 60 | Horizontal alignment |
| X2 | | | Surfactant b | | 60 | Vertical alignment |
| X3 | | | None | | 60 | Oblique alignment |
| X4 | Liquid crystalline monomer b | | | Smectic | 60 | Vertical alignment |
| X5 | Liquid crystalline monomer a | | | Isotropic phase | 130 | Not aligned |
| Y1 | Liquid crystalline monomer c | | Surfactant a | Discotic nematic | 60 | Horizontal alignment |
| Y2 | | | None | | 60 | Vertical alignment |
| Y3 | | | Surfactant a and b | | 60 | Oblique alignment |
| Y4 | | | None | Isotropic phase | 140 | Not aligned |

Liquid crystalline monomer a

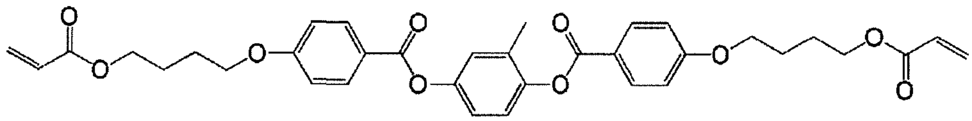

Liquid crystalline monomer b

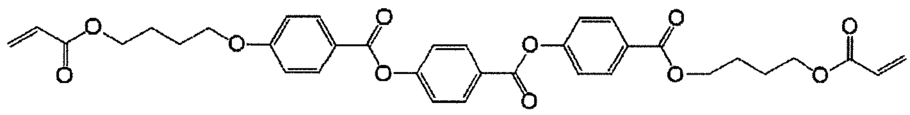

Liquid crystalline monomer c

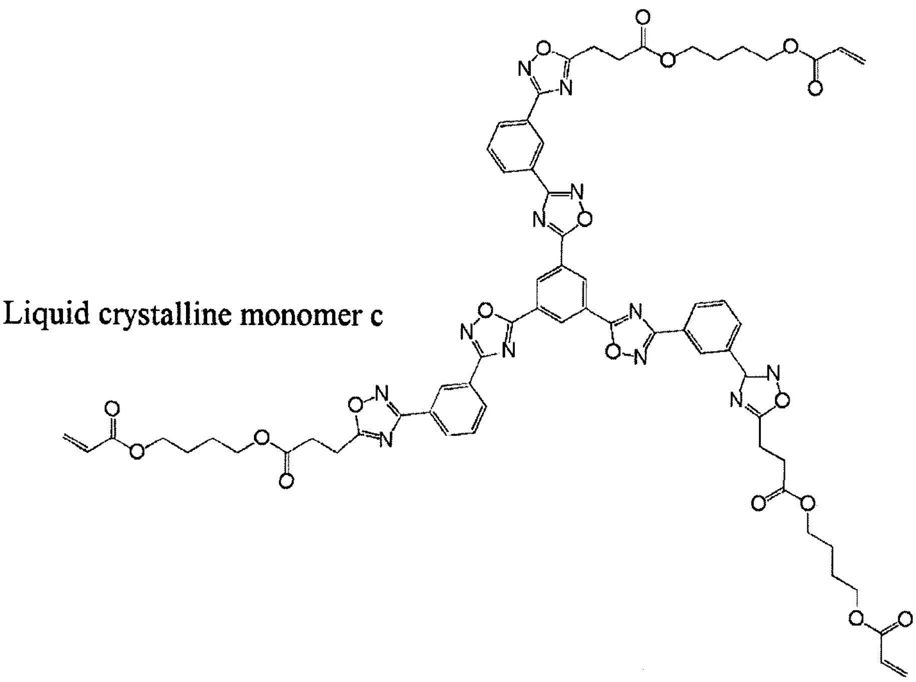

Surfactant a

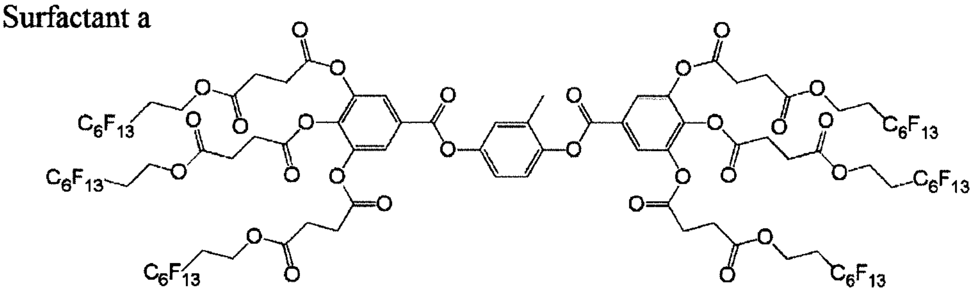

Surfactant b

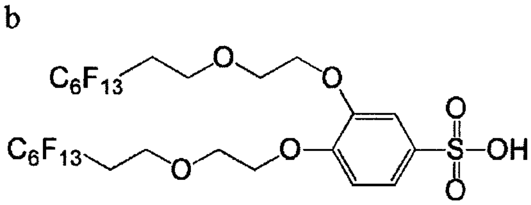

<Source electrode and drain electrode>

Gold was subjected to vacuum vapor deposition on the second gate insulating layer prepared as described above, thereby preparing a source electrode and a drain electrode having a channel length of 50 μm, a channel width of 10 mm, and a thickness of 50 nm.

<Organic semiconductor layer>

Toluene solutions obtained by dissolving organic semiconductors listed in the following table therein at a concentration of 0.5 wt% were prepared. A space between the source electrode and the drain electrode was spin-coated (500 rotations for 20 seconds and 1000 rotations for 20 seconds) with the solutions and organic semiconductor layers were formed such that the layer thickness after drying was set to 150 nm, thereby obtaining OTFTs.

Organic semiconductor a

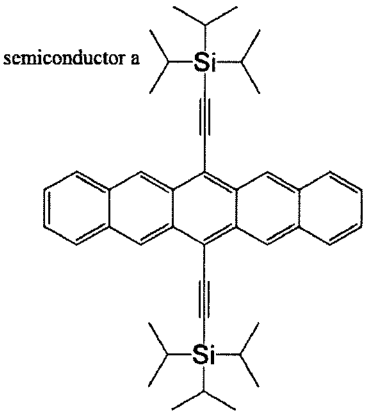

Organic semiconductor b

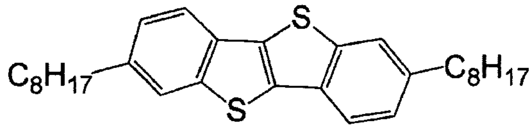

Organic semiconductor c

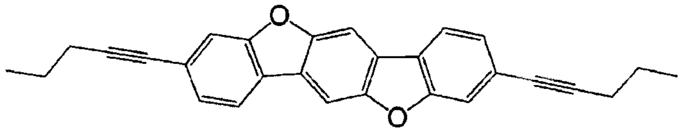

Organic semiconductor d

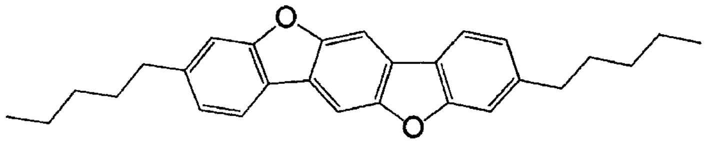

Organic semiconductor e

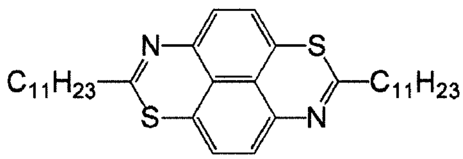

OTFTs having second gate insulating layers X1 to X5 and Y1 to Y4 are respectively referred to as OTFTs Xt1 to Xt5 and OTFTs Yt1 to Yt4.

[Preparation Example 2] Preparation of bottom-gate type OTFT -2

A glass substrate having a thickness of 1.1 mm was coated with a polyimide-based alignment film solution (SE-130, polyimide precursor solution, manufactured by Nissan Chemical Industries, Ltd.) diluted to 2 wt% using N-methyl-2-pyrrolidone, and then the glass electrode was dried at 100°C for 10 minutes. Thereafter, a polyimide film (thickness: 100 nm) was obtained by performing imidization at 230°C for 2 hours. An ITO film having a thickness of 70 nm was formed on a part of the surface of the polyimide film as a gate electrode after a rubbing treatment (alignment treatment) was applied thereto using cotton cloth. Next, a second gate insulating layer was formed in the same manner as that for the above-described X1 such that the gate electrode was covered.

A source electrode, a drain electrode, and an organic semiconductor layer were formed on the second gate insulating layer in the same manner as in Preparation Example 1 described above, thereby obtaining an OTFT. The obtained OTFT was referred to as an OTFT Zt1.

[Preparation Example 3] Preparation of bottom-gate type OTFT -3

An OTFT was prepared in the same manner as in Preparation Example 1 except that alignment and aging were performed at 80°C using a polymer liquid crystalline compound (weight average molecular weight: 9300) having the following repeating unit in place of a liquid crystalline monomer and the polymerization reaction was not performed by irradiation with ultraviolet rays in Preparation Example 1 described above. The following polymer liquid crystalline compound shows a nematic phase in a temperature range of 60°C to 90°C.

Polymer liquid crystalline compound

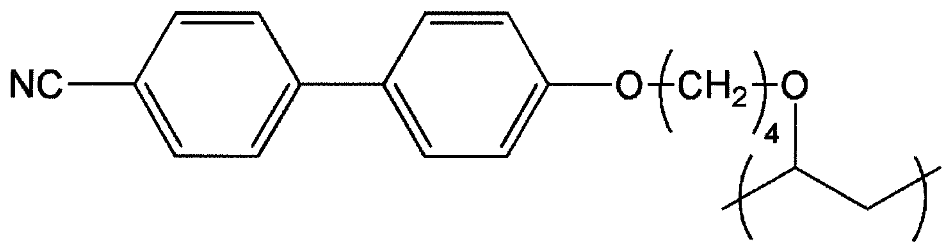

The obtained OTFT was referred to as an OTFT Zt2.

[Test Example 1 Evaluation of performance of OTFT -1

The carrier mobilities ($cm^2/Vs$) of the OTFTs obtained in the above-described respective preparation examples were evaluated according to the following method.

A voltage of -40 V was applied to a space between the source electrode and the drain electrode so that the gate voltage was changed to be in a range of 40 V to -40 V, and a carrier mobility $\mu$ was calculated using the following equation representing a drain current Id.

$$Id = (w/2L)\mu Ci(Vg - Vth)^2$$

(In the equation, L represents the gate length, w represents the gate width, Ci represents the capacity per unit area of the insulating layer, Vg represents the gate voltage, and Vth represents the threshold voltage)

The obtained carrier mobilities were evaluated based on the following evaluation standard. The carrier mobility practically needs to be evaluated as A.

(Evaluation standard of carrier mobility)

A: The carrier mobility was 0.1 or greater.
B: The carrier mobility was 0.01 or greater and less than 0.1.
C: The carrier mobility was less than 0.01.

The results are listed in the following Table 2.

[Table 2]

| OTFT | Example/ Comparative Example | Second gate insulating layer | Organic semiconductor layer | | | | |
|---|---|---|---|---|---|---|---|
| | | | Organic semiconductor a | Organic semiconductor b | Organic semiconductor c | Organic semiconductor d | Organic semiconductor e |
| Xt1 | Example | X1 | A | A | A | A | A |
| Xt2 | Example | X2 | A | A | A | A | A |
| Xt3 | Example | X3 | A | A | A | A | A |
| Xt4 | Example | X4 | A | A | A | A | A |
| Xt5 | Comparative Example | X5 | B | B | B | B | B |
| Yt1 | Example | Y1 | A | A | A | A | A |
| Yt2 | Example | Y2 | A | A | A | A | A |
| Yt3 | Example | Y3 | A | A | A | A | A |
| Yt4 | Comparative Example | Y4 | B | B | B | B | B |
| Zt1 | Comparative Example | Formed on gate electrode | C | C | C | C | C |
| Zt2 | Comparative Example | Aligned state is not immobilized | B | B | B | B | B |

As listed in Table 2, the carrier mobilities of the OTFTs of Xt5 and Yt4 in which a polymer of a liquid crystalline compound constituting a second gate insulating layer was not aligned were degraded. The reason for this was considered that the alignment of the organic semiconductor was not able to be guided in the organic semiconductor layer formed on the second gate insulating layer because the polymer of the liquid crystalline compound constituting the second gate insulating layer was not aligned.

Moreover, the carrier mobility of the OTFT of Zt1 manufactured by forming a gate electrode on the surface of the first gate insulating layer subjected to the alignment treatment and providing the second gate insulating layer so as to cover the gate electrode was greatly reduced. Since the OTFT of Zt1 has a gate electrode being present on a portion between the surface of the first gate insulating layer subjected to the alignment treatment and the second gate insulating layer, it was considered that the alignment regulation force of the second gate insulating layer which was generated due to the alignment treatment applied to the surface of the first gate insulating layer did not sufficiently act, and thus the organic semiconductor in the second gate insulating layer and the organic semiconductor layer formed on the second gate insulating layer was not able to be sufficiently aligned.

In addition, the carrier mobility of the OTFT of Zt2 in which the liquid crystalline polymer compound forming the second gate insulating layer was in an immobilized aligned state was also degraded. The insufficient alignment state due to a low temperature for alignment and aging was considered as one of the causes.

Meanwhile, it was confirmed that the OTFTs of Xt1 to Xt4 and Yt1 to Yt3 of the present invention exhibited high carrier mobilities and were able to perform the switching operation at a high speed.

[Test Example 2] Evaluation of performance of OTFT -2 (heat resistance test)

After the OTFTs obtained in the above-described respective preparation examples were heated at 140°C for 30 minutes, the carrier mobilities were calculated in the same manner as in Test Example 1 described above. The heat resistance of the OTFTs was evaluated based on the obtained carrier mobilities and the following evaluation standard. The heat resistance practically needs to be evaluated as A.

(Evaluation standard of heat resistance)

A: [Carrier mobility after heating]/[carrier mobility before heating] $\geq 0.9$
B: $\leq$ [Carrier mobility after heating]/[carrier mobility before heating] $< 0.9$
C: [Carrier mobility after heating]/[carrier mobility before heating] $< 0.6$

The results are listed in the following Table 3.

[Table 3]

| OTFT | Example/ Comparative Example | Second gate insulating layer | Organic semiconductor layer | | | | |
|---|---|---|---|---|---|---|---|
| | | | Organic semiconductor a | Organic semiconductor b | Organic semiconductor c | Organic semiconductor d | Organic semiconductor e |
| Xt1 | Example | X1 | A | A | A | A | A |
| Xt2 | Example | X2 | A | A | A | A | A |
| Xt3 | Example | X3 | A | A | A | A | A |
| Xt4 | Example | X4 | A | A | A | A | A |
| Xt5 | Comparative Example | X5 | A | A | A | A | A |
| Yt1 | Example | Y1 | A | A | A | A | A |
| Yt2 | Example | Y2 | A | A | A | A | A |
| Yt3 | Example | Y3 | A | A | A | A | A |
| Yt4 | Comparative Example | Y4 | A | A | A | A | A |
| Zt1 | Comparative Example | Formed on gate electrode | A | A | A | A | A |
| Zt2 | Comparative Example | Aligned state is not immobilized | C | C | C | C | C |

As shown from the above-described Table 3, the carrier mobility was greatly degraded when the OTFT Zt2, in which the aligned state of the liquid crystalline compound constituting the second gate insulating layer was not immobilized, was exposed to the above-described high temperature. The reason for this is considered that the alignment was lost when the polymer liquid crystalline compound constituting the second gate insulating layer in Zt2 was exposed to a high temperature.

On the contrary, it was shown that the carrier mobility was not substantially degraded and the heat resistance was excellent even when Xt1 to Xt4 and Yt1 to Yt3 incorporated in the present invention were treated at 140°C for 30 minutes.

The present invention has been described with reference to the embodiments, but the detailed description of the invention is not limited unless otherwise noted and the present invention should be broadly interpreted without departing from the spirit and the scope described in the aspects of the invention.

Explanation of References

The present application claims priority based on Japanese Patent Application No. 2014-045166 filed in Japan on March 7, 2014 and the contents of which are incorporated herein by reference.

1: organic semiconductor layer
2: gate insulating layer
2A: first gate insulating layer
2B: second gate insulating layer
2a: surface of first gate insulating layer (surface subjected to alignment treatment)
3: source electrode
4: drain electrode
5: gate electrode
6: substrate

## Claims

**1.** A bottom gate type organic thin-film transistor comprising:

a substrate;
a gate electrode provided on the substrate;
a first gate insulating layer provided to cover the gate electrode;
a second gate insulating layer provided on the first gate insulating layer;
an organic semiconductor layer provided on the second gate insulating layer; and
a source electrode and a drain electrode provided in contact with the organic semiconductor layer and connected to each other through the organic semiconductor layer,
wherein the surface of the first gate insulating layer on the second gate insulating layer side is subjected to an alignment treatment, and
the second gate insulating layer comprises polymerized and immobilized liquid crystalline compound aligned in accordance with the alignment treatment, which is formed by polymerizing and immobilizing a polymerizable liquid crystalline compound in the aligned state.

**2.** The organic thin-film transistor according to claim 1,

wherein the polymerizable liquid crystalline compound is a rod-like liquid crystalline compound, and
a liquid crystal phase of the polymerizable liquid crystalline compound is a nematic phase or a smectic phase in the aligned state in accordance with the alignment treatment.

**3.** The organic thin-film transistor according to claim 1,

wherein the polymerizable liquid crystalline compound is a discotic liquid crystalline compound, and
a liquid crystal phase of the polymerizable liquid crystalline compound is a discotic nematic phase in the aligned state in accordance with the alignment treatment.

4. The organic thin-film transistor according to any one of claims 1 to 3, wherein the polymerized and immobilized liquid crystalline compound is aligned horizontally on the surface of the second gate insulating layer on the organic semiconductor layer side.

5. The organic thin-film transistor according to any one of claims 1 to 3, wherein the polymerized and immobilized liquid crystalline compound is aligned vertically on the surface of the second gate insulating layer on the organic semiconductor layer side.

6. The organic thin-film transistor according to any one of claims 1 to 3, wherein the polymerized and immobilized liquid crystalline compound is aligned obliquely on the surface of the second gate insulating layer on the organic semiconductor layer side.

7. The organic thin-film transistor according to any one of claims 1 to 6, wherein the first gate insulating layer contains an organic polymer compound selected from polyimide, polyvinyl phenol, a novolak resin, polystyrene, poly(meth)acrylate, an epoxy resin, epoxy (meth)acrylate, polyvinyl alcohol, a fluorine resin, polycycloolefin, polysilsesquioxane, polysiloxane, polyester, polyether sulfone, and polyether ketone.

FIG. 1A

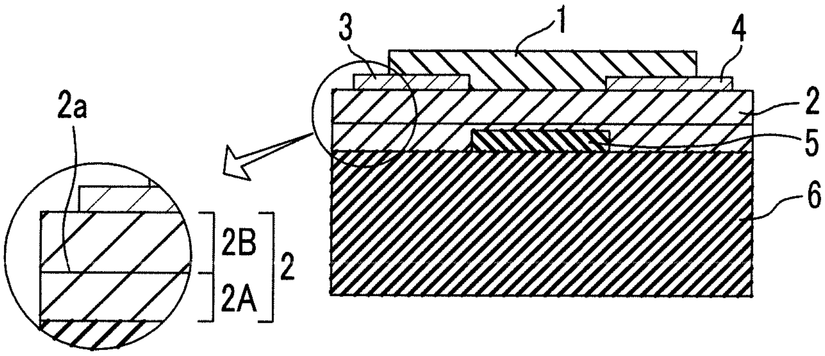


FIG. 1B

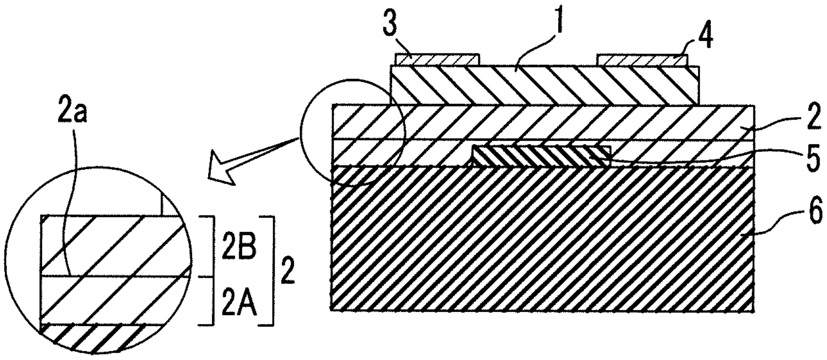

## INTERNATIONAL SEARCH REPORT

International application No.
PCT/JP2015/055706

**A. CLASSIFICATION OF SUBJECT MATTER**
*H01L29/786*(2006.01)i, *H01L51/05*(2006.01)i, *H01L51/30*(2006.01)i

According to International Patent Classification (IPC) or to both national classification and IPC

**B. FIELDS SEARCHED**

Minimum documentation searched (classification system followed by classification symbols)
H01L29/786, H01L51/05, H01L51/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2005-72200 A (Canon Inc.), 17 March 2005 (17.03.2005), paragraphs [0016] to [0085]; fig. 3 (Family: none) | 1-7 |
| Y | JP 2012-253132 A (Fujifilm Corp.), 20 December 2012 (20.12.2012), paragraphs [0009] to [0099] & WO 2012/165403 A1 | 1-7 |
| A | JP 2012-51862 A (Hiroshima University), 15 March 2012 (15.03.2012), paragraphs [0017] to [0068] (Family: none) | 1-7 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 06 April 2015 (06.04.15) | 21 April 2015 (21.04.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | <br><br>Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 4349307 B
- JP 2005072200 A
- JP 2013214649 A
- JP 2011186069 A
- JP 2010285518 A
- JP 2012163946 A
- JP 2005354012 A
- JP 2006303465 A
- JP 8027284 A
- JP H0827284 A
- JP 2009097002 A
- JP 2007108732 A
- US 4683327 A
- US 5622648 A
- US 5770107 A
- WO 9522586 A
- WO 9524455 A
- WO 9700600 A
- WO 9823580 A
- WO 9852905 A
- JP 1272551 A
- JP H01272551 A
- JP 6016616 A
- JP H0616616 A
- JP 7110469 A
- JP H07110469 A
- JP 10080081 A
- JP H1180081 A
- JP 2001328973 A
- JP 11352328 A
- JP H11352328 A
- JP 2002020363 A
- JP 2001330725 A
- JP 2005179636 A
- JP 8095030 A
- JP H0895030 A
- US 2367661 A
- US 2367670 A
- US 2448828 A
- US 2722512 A
- US 3046127 A
- US 2951758 A
- US 3549367 A
- JP 60105667 A
- US 4239850 A
- US 4212970 A
- JP 2014045166 A


### Non-patent literature cited in the description


- Handbook of Liquid Crystal. MARUZEN Co., Ltd, 30 October 2000, 226-229
- **C. DESTRADE et al.** *Mol. Crysr. Liq. Cryst.,* 1981, vol. 71, 111
- liquid crystal chemistry. 1994
- **B. KOHNE et al.** *Angew. Chem. Soc. Chem. Comm.,* 1985, 1794
- **J. ZHANG et al.** *J. Am. Chem. Soc.,* 1994, vol. 116, 2655
- *Makromol. Chem.,* 1989, vol. 190, 2255
- *Advanced Materials,* 1993, vol. 5, 107